(19) **Europäisches Patentamt European Patent Office Office européen des brevets**

(11) **EP 4 241 094 B1**

(12) **EUROPEAN PATENT SPECIFICATION**

(45) Date of publication and mention of the grant of the patent:
**16.10.2024  Bulletin 2024/42**

(21) Application number: **21815666.9**

(22) Date of filing: **05.11.2021**

(51) International Patent Classification (IPC):
*G01R 27/26* (2006.01)    *G01R 31/72* (2020.01)
*G06F 30/367* (2020.01)

(52) Cooperative Patent Classification (CPC):
**G01R 27/2611; G01R 31/72;** G01 R 31/40;
G06F 30/367

(86) International application number:
**PCT/IB2021/060270**

(87) International publication number:
**WO 2022/097086 (12.05.2022 Gazette 2022/19)**

(54) **METHOD, MEASURING STATION AND SYSTEM FOR DETERMINING THE BEHAVIOUR OF ONE ELECTRICAL OR ELECTRONIC POWER COMPONENT**

VERFAHREN, MESSSTATION UND SYSTEM ZUR BESTIMMUNG DES VERHALTENS EINES ELEKTRISCHEN ODER ELEKTRONISCHEN LEISTUNGSBAUELEMENTS

PROCÉDÉ, POSTE DE MESURE ET SYSTÈME DE DÉTERMINATION DU COMPORTEMENT D'UN COMPOSANT DE PUISSANCE ÉLECTRIQUE OU ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.11.2020  IT 202000026599**

(43) Date of publication of application:
**13.09.2023  Bulletin 2023/37**

(73) Proprietor: **Ipera S.r.l.**
**84122 Salerno (SA) (IT)**

(72) Inventors:
• **FEMIA, Nicola**
  **84122 Salerno (SA) (IT)**
• **DI CAPUA, Giulia**
  **84122 Salerno (SA) (IT)**

(74) Representative: **IP Sextant s.r.l.**
**Via A. Salandra, n.18**
**00187 Rome (IT)**

(56) References cited:
**US-A- 5 793 640       US-A1- 2005 021 255**
**US-A1- 2014 372 059   US-A1- 2016 132 625**

## EP 4 241 094 B1

**Description**

The present invention relates to a method for determining the behaviour of an electrical or electronic power component, more particularly of an inductor, operating under typical operating conditions of power generators, wherein that inductor is used as an energy periodic temporary storage element, to carry out a static energy conversion process.

The present invention also relates to a measuring station and a system configured to implement such a method.

Before going into the merits of the present invention it is noted that explicit reference will be made hereinafter to an inductor as an element of periodic temporary storage of energy. However, it must be kept in mind that the present invention can be applied in a completely analogous way also to capacitors as will become clear in the following.

The operating conditions of an inductor which are of particular interest for the present invention are those imposed by a periodic charge-discharge process. In said process, a zero mean square wave time-varying voltage $v_L(t)$ is applied to the inductor terminals, for example by means of active and passive semiconductor devices, which operate as electronic switches that alternately connect the terminals of the inductor to electronic components configured to impose a positive or negative voltage value, thus obtaining in a first step, an energy transfer from an energy source towards the inductor and, in the second step, an energy transfer from the inductor to a load.

The electrical behaviour of the inductor, resulting from this periodic charge-discharge process, can be determined based on the trend of the current $i_L(t)$ flowing therethrough, which current varies over time. The current flowing through such an inductor during the periodic charge-discharge process is comparable to a periodic triangular wave, with a positive slope in the charging step of the inductor and a negative slope in the discharge step of the inductor. The triangular wave of the current flowing through the inductor can be subjected to more or less accentuated slope variations, in each of the two steps (charge and/or discharge), due to the more or less abrupt occurrence of the saturation phenomenon of the inductor electronic core, as the variable current flowing therethrough varies.

As a rule, the behaviour of a commercially available inductor is experimentally determined by its manufacturer, using different types of techniques, with the aim of quantifying one of its characteristic parameters, specifically the self-inductance coefficient L. The self-inductance coefficient is usually represented in graphical form as a function of the variable average current flowing through the inductor and parametrized as a function of the environmental temperature.

Traditionally, a manufacturer of a commercially available inductor also obtains, from the results of experimental tests that he performs on the component, useful information for the formulation of heuristic loss equations (for example through Steinmetz formulas), depending on the conditions in which such component can operate, for example when the frequency varies.

Over time, techniques and apparatuses have been developed for determining the behaviour of inductors, in relation to the varying conditions in which they operate.

These determination techniques with their respective apparatuses, however, suffer from many drawbacks. For example, in some cases they are not informative, as they provide parameters that do not assume unique values, as they are subject to variations according to the operational parameters of the components. In particular, reference is made to the inductor's self-induction coefficient L, expressed at most as a function of the average current flowing therethrough and the environmental temperature. The self-induction coefficient L is traditionally provided as it is usually used to calculate the performance of inductors, such as peak-to-peak current ripple and losses, although, in fact, it does not assume a unique value as it varies according to, for example, the working frequency, the voltage and the duty-cycle, as well as the current and the temperature.

Grids of parameter values are also traditionally used to generate signals to be sent to the inductors during the execution of experimental tests thereon. Those grids cover multidimensional domains, the exploration of which is carried out through nested scanning cycles of each quantity, which nested scanning cycles may include - if not appropriately restricted - n-tuple of operational quantities corresponding to unsustainable operational conditions of the inductor being evaluated and, therefore, such that they compromise the test results due to inductor failures that may occur and the consequent possible damage to the hardware used for the test. This type of approach is also very demanding from a computational point of view.

The determination of the behaviour of the inductors is also traditionally performed by carrying out tests on these components in small-signal sinusoidal regime, which tests however do not reflect the real working conditions of the inductors in power generators.

Complex architectures of test systems are also adopted to determine the behaviour of these inductors, which architectures require a programmable electronic load for the imposition of the desired current on the inductor under test and for the automation of the test cycles.

Some examples of the above traditional apparatuses and methods are, for example, taught in EP2807589B1, US7307412B1 and US20120316817A1. Further traditional methods for determining a characteristic parameter of a device are described in US 5793640 and in US 2016/0132625.

In any case, all the methods traditionally used provide information that does not express in a direct and easy to understand way, the relationship between the operational conditions to which an inductor is normally subjected (for

2

example, the frequency of oscillation of the voltage, average current and the environmental temperature) and its response parameters such as, for example, current ripple, dissipated power and surface temperature.

The need is therefore felt to improve the state of the art in the field of electrical or electronic power components and, thus, the main object of the present invention is to provide a method for determining the behaviour of an electrical or electronic power component which is safe, in the sense that its implementation does not cause faults in the electrical or electronic power component under test or in the used hardware, that is less demanding from a computational point of view, that is reliable and provides for more easily interpretable and useful results for the purpose, compared to traditional methods.

A further object of the present invention is to provide for a measuring station, configured for the implementation of the aforementioned method.

Not the least object of the present invention is to provide a system for the implementation of the method for determining the behaviour of an electrical or electronic power component, which is easy to implement and use.

It is a specific object of the present invention a method for determining the behaviour of one electrical or electronic power component, with respect to a working limit condition, the method comprising the following operational steps:

A. defining one three-dimensional mathematical space of operational parameters of interest for said electrical or electronic power component, wherein the coordinates of an n-th point $P_n$ of said three-dimensional mathematical space correspond to specific values of said operational parameters of interest for said electrical or electronic power component;

B. defining one field of exploration of said three-dimensional mathematical space, one working limit condition for said electrical or electronic power component and one set R of response parameters of interest for said electrical or electronic power component;

C. exploring, said three-dimensional mathematical space by:

- generating at least one stimulus, determined based on the coordinates of the points $P_n$ of said three-dimensional mathematical space and on said field of exploration,
- applying said at least one stimulus, to said at least one electrical or electronic power component, and
- detecting one corresponding response to said stimulus thereby applied, from said electrical or electronic power component, and

based on said response thereby detected, determining, and storing one finite subset of points $P^*_n$ of said three-dimensional mathematical space among the points $P_n$ of said three-dimensional mathematical space, for which said working limit condition of said electronic power component is met; and

D. determining one mathematical model that analytically describes the locus of said points $P^*_n$ of said three-dimensional mathematical space thereby stored, thereby obtaining the locus of said operational parameters that determine a response of said electrical or electronic power component hat meets said working limit condition.

According to another aspect of the invention, said operational parameters of interest for said electrical or electronic power component can be selected among:

- one equivalent voltage to be applied to said electrical or electronic power component;
- one switching frequency for one entire charge-discharge cycle of said electrical or electronic power component;
- one average current flowing thorough said electrical or electronic power component; and
- one temperature of the environment wherein said electrical or electronic power component is operational.

According to a further aspect of the invention, said three-dimensional mathematical space can be defined by assigning to each one of said operational parameters of interest of said electrical or electronic power component, one corresponding mathematical axis of an Euclidean three-dimensional mathematical space.

According to an additional aspect of the invention, said field of exploration can be defined by selecting:

- one finite subset of points $P_n$ of said three-dimensional mathematical space; and
- one ordered set of three directions of exploration of the points of said field of exploration, from any point $P_{n-1}$ to a next point $P_n$, each direction of exploration being optionally parallel to a respective axis of said three-dimensional mathematical space.

According to another aspect of the invention, the exploration of said three-dimensional mathematical space can be carried out, starting from one starting point $P_n$ of said field of exploration, along said directions of exploration, in an orderly way, and according to one exploration rule such that the coordinates of an explored n-th point $P_n$ of said three-dimensional mathematical space differ from those of a previous point $P_{n-1}$, for the value of one or more of its components.

According to a further aspect of the invention, the coordinates of said points $P_n$ of said field of exploration can have values comprised between one minimum value and one maximum value of respective operational parameters and the finite number of said points $P_n$ of said field of exploration can be a function, for each one of said directions of exploration of said three-dimensional mathematical space, of

- one number of samples; and
- one offset between one sample and the next one along the respective direction of exploration.

According to an additional aspect of the invention, for each direction of said directions for exploration:

- said number of samples can be fixed, and said offset can be fixed and constant; or
- said number of samples can be fixed, and said offset can vary between two subsequent samples, optionally according to one function selectable between a pre-set logarithmic, power, trigonometric, transcendent, or numerical series function; or
- said number of samples can depend on one offset that is calculated, during said exploration of said exploration field (4), for each point $P_n$, optionally based on one value of one set R of response parameters, which response parameters are calculated at the two points $P_{n-1}$ e $P_{n-2}$ that were last explored in said field of exploration.

According to another aspect of the invention, the compliance or not of said working limit condition in any point $P_n$ of said three-dimensional mathematical space can depend on the value of at least one response parameter of said set R of response parameters of said electrical or electronic power component, the response parameters being determined based on the response detected from said electrical or electronic power component, after the application of said stimulus to its terminals, and on a pre-set search logic.

According to a further aspect of the invention, said response parameter of said set R of response parameters of said electrical or electronic power component can be one among:

- one peak-to-peak variation of a current that varies with time and flows through said electrical or electronic power component;
- one surface temperature of said electrical or electronic power component;
- one average electrical power dissipated by said electrical or electronic power component.

According to an additional aspect of the invention, said working limit condition of said electrical or electronic power component can be a function of a prefixed threshold value for each response parameter.

According to another aspect of the invention, said at least one response parameter can be compliant with said at least one working limit condition if its value is lower than or equal to a respective threshold value.

According to another aspect of the invention, said step C can comprise:

C.1 selecting, through a data control and processing unit, one starting point $P_n$ comprised in said exploration field (4) and one first direction of exploration of said field of exploration;

C.2 generating, through one stimulus generating device, one stimulus comprising one varying over time voltage and one constant average current, based on the value of the coordinates of said point $P_n$ just selected, and applying said stimulus thereby generated to the terminals of said electrical or electronic power component;

C.3 detecting at the terminals of said electrical or electronic power component, through one detecting device, in reply to said stimulus thereby applied, at least one corresponding current which varies over time, flowing through said electrical or electronic power component, and one corresponding surface temperature;

C.4 determine, through said data control and processing unit, said set R of response parameters, based on said current and said surface temperature thereby detected; and

C.5 compare, through said data control and processing unit, each element of said set R of response parameters with said working limit condition; and

C.6 if said working limit condition is met in said point $P_n$:

C.6.1 selecting a new point $P_n$ of said three-dimensional mathematical space, along said first selected direction of exploration; and

C.6.2 if said point $P_n$ is comprised within said field of exploration, going back to step C.2; otherwise going to step C.8

C.7 if said working limit condition is not met in said point $P_n$:

C.7.1 if said point $P_n$ just selected is the starting point of said field of exploration:

C.7.1.1 selecting a new point $P_n$ of said three-dimensional mathematical space, along said first selected direction of exploration; and

C.7.1.2 if said new point $P_n$ is comprised within said field of exploration:

C.7.1.2.1 carrying out steps C.2-C.5 and

C.7.1.2.2 if said working limit condition is not met for said new point $P_n$, going back to step C.7.1.1, otherwise going to step C.6;

otherwise going to step C.8

otherwise

C.7.2 if said point $P_n$ just selected and the point $P_{n-1}$ previous to that are placed along said first direction of exploration:

C.7.2.1 determining, through said data control and processing unit, and storing, in a storage unit, the coordinates of another point $P^*_n$ of the three-dimensional space 3, that is comprised in the neighbourhood of said point $P_n$ of said field of exploration, along said first selected direction of exploration, wherein said working limit condition is met;

C.7.2.2 selecting the point $P_{n-1}$ previous to said $P_n$ and, starting from that, a new point $P_n$, along the second direction of exploration; and

C.7.2.3 if said newly selected point $P_n$ is comprised within said field of exploration, going back to step C.2; otherwise going to step C.8

otherwise

C.7.3 if said point $P_n$ just selected and the point $P_{n-1}$ previous to that are placed along the second direction of exploration:

C.7.3.1 selecting a new point $P_n$ of the three-dimensional mathematical space, along the first selected direction of exploration; and

C.7.3.2 if said newly selected point $P_n$ is comprised within said field of exploration, going back to step C.2; otherwise going to step C.8

C.8 if said point $P_n$ just selected is not comprised within said field of exploration:

C.8.1 selecting, along said second direction of exploration, a new point $P_n$ of the three-dimensional mathematical space, starting from the previously selected point $P_{n-1}$ and, if the newly selected point $P_n$ is comprised within said field of exploration, going back to step C.2; otherwise

C.8.2 selecting, along said third direction of exploration, a new point $P_n$ of the three-dimensional mathematical space, starting from the previously selected point $P_{n-1}$ and, if the newly selected point $P_n$ is comprised within said field of exploration, going back to step C.2; otherwise going to said step D of said method.

According to an additional aspect of the invention, the stored coordinates of said point $P^*_n$ of said mathematical space, which point is comprised in the neighbourhood of said point $P_n$ of said field of exploration, can be calculated through an interpolation formula, optionally a linear one.

According to another aspect of the invention, said step D can comprises applying to said points thereby stored, through said data control and processing unit, at least one Genetic Programming or Grammatical Evolution algorithm.

It is further a specific object of the invention, a measuring station, configured for implementing the method for determining the behaviour of an electrical or electronic power component as described above, comprising:

- one data control and processing unit, configured for defining said three-dimensional mathematical space, said field of exploration, said working limit condition, said set R of response parameters, and configured for comparing said set R with said working limit condition;
- one stimulus generating device, operatively connected to said data control and processing unit and configured for generating at least one stimulus, the stimulus comprising at least one zero mean and square wave voltage and one constant average current for said electrical or electronic power component, based on the value of the coordinates of said point $P_n$ of said three-dimensional mathematical space, said coordinates being associated to respective values of said operational parameters of said electrical or electronic power component, and for applying said stimulus thereby generated to said electrical or electronic power component;

- one detecting device, operatively connected to said data control and processing unit and configured for detecting said at least one varying overtime current and one surface temperature of said electrical or electronic power component, in reply to said stimulus thereby applied;
- at least one storage unit, operatively connected to said data control and processing unit and configured for storing the coordinates of the points $P^*_n$ of said mathematical space wherein said working limit condition is met;

wherein said data control and processing unit is configured for applying to said coordinates of said points $P^*_n$ thereby stored, at least one mathematical algorithm, optionally a Genetic Programming or Grammatical Evolution algorithm, said at least one mathematical algorithm providing for in output a description, in analytical form, of the locus of said points $P^*_n$, and therefore the locus of the corresponding operational parameters that determine a response from said electrical or electronic power component that meets said at least one working limit condition.

According to another aspect of the invention, said one stimulus generating device and said detecting device can be obtained through three power converter stages operatively connected in cascade according to an Opposition Method, so as to:

- subject said at least one electrical or electronic power component to said at least one stimulus, based on the value of the coordinates of said point $P_n$; and
- detect at least one varying over time current and one surface temperature $T_s$ of said electrical or electronic power component.

According to a further aspect of the invention, said three power converter stages can comprise an Input Stage, a Test Stage, and an Output Stage, wherein the Test Stage is connected between the Input Stage and the Output stage and is further configured to be connected to said electrical or electronic power component.

According to an additional aspect of the invention, said measuring station can comprise downstream of said Output Stage one switching element for the current output from said Output Stage, toward the input of the Test Stage or an external load.

According to a further aspect of the invention, said Input Stage can be configured to work in closed loop and provide in input to said Test Stage one direct voltage, through the adjustment of the output voltage thereof, and said Test stage is configured to work in open loop and provide for a switching frequency of said zero mean and square wave voltage, through the adjustment of its own frequency and duty cycle.

According to another aspect of the invention, said Output stage can be configured to operate in closed loop and impose at the output of said Test Stage a direct current, through the adjustment of its own input average current.

According to an additional aspect of the invention, said measuring station can comprise:

- one printed circuit having conductive paths, configured for imposing said stimulus to said electrical or electronic power component, wherein said conductive paths have at least one surface portion configured for electrically entering into contact with said electrical or electronic power component; and
- one positioning system for said electrical or electronic power component on said printed circuit, wherein said electrical or electronic power component is in electrical contact with said conductive paths of said printed circuit, without need for welds.

According to a further aspect of the invention, said positioning system can comprise:

- one positioning plate; and
- one group for the elastic anchoring of said positioning plate to said printed circuit;

said electrical or electronic power component being configured for being placed between said printed circuit and said positioning plate and being subjected to one pressure toward said conductive paths of said printed circuit, through said elastic anchoring group.

According to a further aspect of the invention, said elastic anchoring group can comprise one couple of elastically charged screws, configured for being screwed on said printed circuit, passing through suitable openings obtained in said positioning plates.

According to an additional aspect of the invention, said conductive paths can have a polygonal configuration, optionally a trapezoidal configuration.

According to another aspect of the invention, said detecting device can comprise at least one temperature sensor, operatively connected to said data control and processing unit, and configured for detecting said surface temperature of said electrical or electronic power component and for transmitting it to said data control and processing unit.

It is also a specific object of the invention a system for implementing the method for determining the behaviour of an electrical or electronic power component as described above, comprising at least one measuring station as described above and at least one remote processing unit, wherein said measuring station and said remote processing unit are operatively connected to each other, optionally through one network, optionally through one cable or wirelessly, and wherein said data control and processing unit of said measuring station is configured to send to said at least one remote processing unit said coordinates of said points $P^*_n$ thereby stored, and said at least one remote processing unit is configured to apply at least one mathematical algorithm, optionally a Genetic Programming or Grammatical Evolution algorithm, providing for in output a description, in analytical form, of the locus of said points $P^*_n$, and therefore the locus of the corresponding operational parameters that determine a response from said electrical or electronic power component that meets at least one working limit condition.

The present invention will be now described, for illustrative but not limiting purposes, according to its preferred embodiments, with particular reference to the Figures of the accompanying drawings, wherein:

Figure 1 shows, above, the graph of a typical voltage $v_L(t)$ varying over time, that can be applied to the terminals of an inductor, for example in a PWM dc-dc converter, according to the method of the present invention and, below, the typical trend of the corresponding current $i_L(t)$, that also varies in time, flowing through the inductor in response to the applied voltage $v_L(t)$;

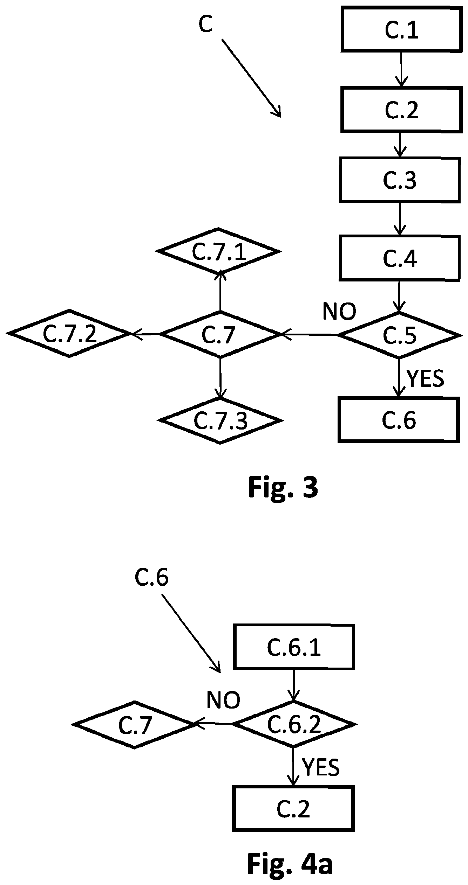

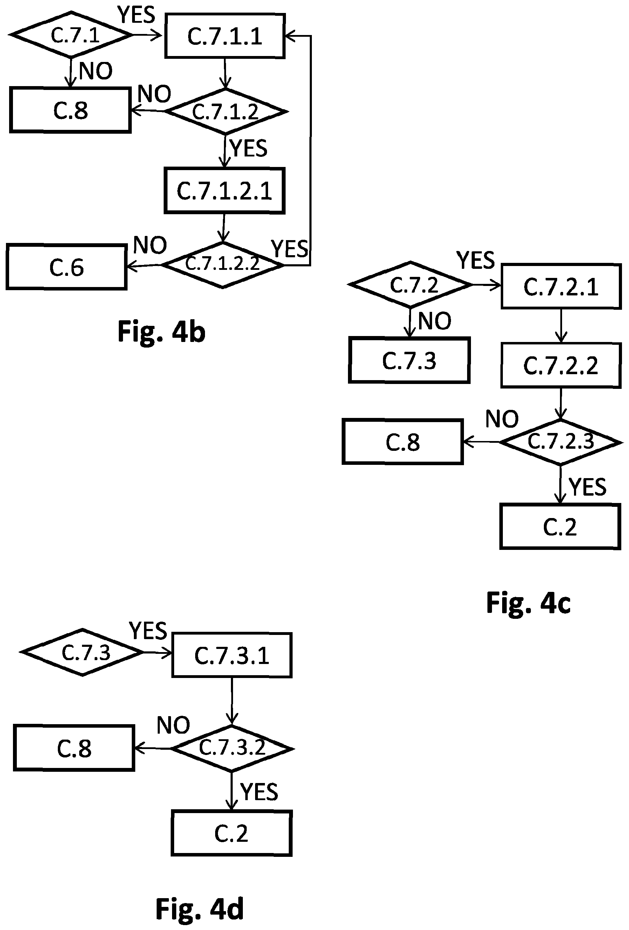

Figures 2 to 6 show, respectively, a block diagram of the main steps of the method according to the invention, a first, second, third, fourth, fifth and sixth detail of the steps thereof, as well as a tree structure of a preferred algorithm, which is optionally employed in said method;

Figure 7 illustrates a three-dimensional mathematical space and its field of exploration, defined according to the method of the invention;

Figure 8a is a graphical representation of an example of exploration of the field of exploration of Figure 7, along a first and a second exploration direction, for determining the set of operational parameters of an inductor that meet a first limit condition for the inductor under investigation (specifically, that the dissipated power is $P_d=P_{d,ref}=200mW$);

Figure 8b is a graphical representation of a variant of the example of exploration of Figure 8a;

Figure 9 shows a graphical representation of an example of exploration of the field of exploration of Figure 7, along a first and a second exploration direction, for determining the set of operational parameters of an inductor that meet a second limit condition for the inductor under investigation (specifically, that the peak-to-peak variation of the oscillation of the current flowing through the inductor is $\Delta i_{Lpp}=\Delta i_{Lpp,ref}=1.0A$);

Figure 10 is a graphical representation of an example of exploration of the field of exploration of Figure 7, along a first and a second exploration direction, for determining the set of operational parameters of an inductor that meet a third limit condition for the inductor under investigation (specifically, that its surface temperature is $T_s=T_{s,ref}=120°C$);

Figure 11a is an example of a graphical representation of the locations of the operational parameters that determine an inductor response that meets, (a) the first limit condition, wherein in particular $P_d=P_{d,ref}=200mW$, (b) the second limit condition, wherein in particular $\Delta i_{LPP}=\Delta i_{Lpp,ref}=1.0A$ and (c) the third limit condition, wherein in particular $T_s=T_{s,ref}=120°C$, respectively.

Figure 11b shows some examples of functions that describe in analytic form the locus of the operational parameters hat determine an inductor response that complies with the first limit condition, wherein in particular $P_d=P_{d,ref}=200mW$;

Figure 12 shows a schematic representation of the main blocks of a measuring station that can be used for the implementation of the method according to the invention;

Figure 13 illustrates a block diagram of a preferred configuration of an Input Stage of the measuring station of Figure 12;

Figure 14 is a block diagram of a preferred configuration of a Test Stage of the measuring station of Figure 12, wherein the inductor under investigation is seen connected;

Figure 15 shows a block diagram of a preferred configuration of an Output Stage of the measuring station of Figure 12;

Figure 16 illustrates a detail of the measuring station of Figure 12, in particular of the Test Stage, on which an inductor is mounted for the implementation of the method of the present invention;

Figure 17 is another view of the detail of Figure 16, wherein some parts have been removed; and

Figures 18 to 20 show respective configurations of a system for implementing the method of the present invention.

In the enclosed Figures the same reference numbers will be used for similar elements.

Before going into the merits of the description, it is specified that in this description the terms "inductor", "electrical or electronic power component", "electrical or electronic component" or "component" may be used in a completely equivalent way, that is in any case clear from the context.

It is also specified that, according to the method of the present invention, an inductor operational in an environment having temperature $T_a$, can be subjected to a stimulus comprising:

- a voltage waveform $v_L(t)$, to be applied to its terminals, e

- an average current flowing therethrough $I_{L,av} = f_{sw} \int_0^{T_{sw}} i_L(t)dt$ during the charge-discharge cycle.

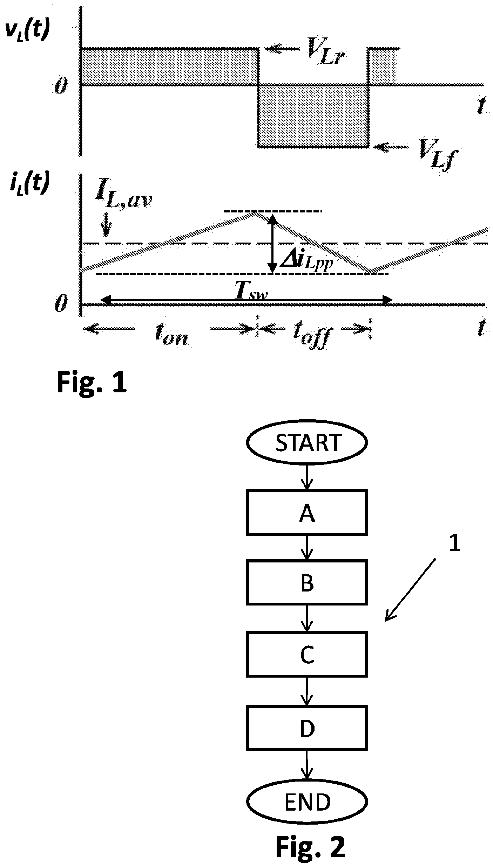

With particular reference to Figure 1, the waveform of the varying over time voltage $v_L(t)$ that according to the method of the invention is applied to the inductor, can be defined using the following parameters:

1) a value of the positive voltage $V_{Lr}$ applied to the inductor during the charge step (for a time interval $t_{on}$);
2) a value of the negative voltage $V_{Lf}$ applied to the inductor during the discharge step (for a time interval $t_{off}$);
3) A frequency $f_{sw}=1/(t_{on}+t_{off})=1/T_{sw}$ of the repetition of the charge-discharge cycle (switching frequency)
4) a relative duration of the charging time $D_{on} = t_{on}f_{sw}$ (duty-cycle), between 0 and 1.

The response of an inductor operational at an environmental temperature $T_a$, to which the stimulus described above has been applied, i.e. a variable voltage $v_L(t)$ as described above and a certain average current $I_{L,av}$, can be described through the following parameters, again shown in Figure 1, namely:

1) a peak-to-peak value of the oscillation of the current $\Delta i_{Lpp}$;
2) a surface temperature $T_s$ of the inductor; and
3) an average electrical power $P_d$ dissipated d by the inductor, according to the formula

$$P_d = f_{sw} \int_0^{T_{sw}} v_L(t)i_L(t)dt.$$

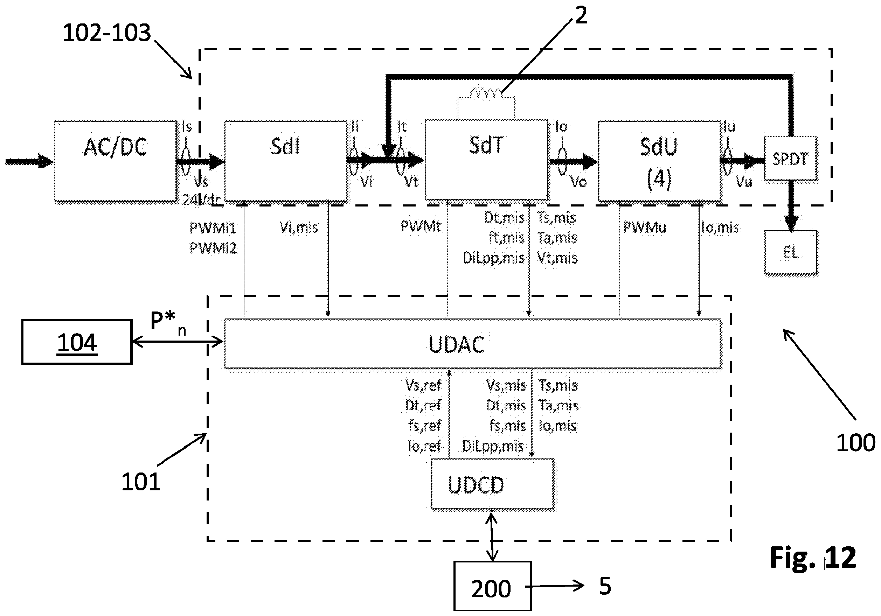

This said, the method according to the present invention, indicated by reference number 1 is provided for determining the behaviour of an electrical or electronic power component (represented in Figures 12, 14, 16 and 17), more particularly of an inductor 2 configured to operate under typical operational conditions of power generators, and comprises (see in particular Figure 2) one initial step A, wherein, for example through a data control and processing unit (for example represented in Figure 12 with reference number 101 and which will be better described in the following ), a three-dimensional mathematical space 3 of operational parameters of interest for the inductor 2 is defined, wherein the coordinates $(p_{n1}, p_{n2}, p_{n3})$ of an n-th point P of the three-dimensional mathematical space 3 correspond to specific values of the operational parameters of interest for said inductor 2.

More specifically, according to a preferred embodiment of the method of the invention, the operational parameters of interest for the inductor, the behaviour of which is to be determined, are three and are selected from:

- one equivalent voltage $V_{eq}$ to be applied to the inductor 2;
- one switching frequency $f_{sw}$ for one entire charge-discharge cycle of the inductor 2;
- one average current $I_L$ flowing through the inductor 2; and
- one temperature $T_a$ of the environment wherein the inductor 2 is operating.

On the basis of three of the above operational parameters of interest for the inductor 2, the three-dimensional mathematical space 3 is defined, according to method 1 of the invention, by assigning to each of these operational parameters of interest, a corresponding mathematical axis of a Euclidean three-dimensional mathematical space 3.

Then, method 1 according to the invention comprises a second step B, which is always performed for example by means of a data control and processing unit, wherein an exploration field 4 of the three-dimensional mathematical space 3 is defined. At step B of the invention method 1, a working limit condition of interest for the inductor and a set R of response parameters for that inductor are also defined, as will be seen below.

In this regard, according to a preferred embodiment of the invention, the exploration field 4 is defined by selecting:

- one finite subset of points $P_n$ of the three-dimensional mathematical space 3; and
- one ordered set of three directions of exploration of the points of said exploration field 4, from any point $P_{n-1}$ to one next point $P_n$, wherein, according to a preferred embodiment of the invention, each direction of exploration is optionally parallel to a respective axis of the three-dimensional mathematical space 3.

According to a particularly advantageous aspect of the invention, the coordinates of the points $P_n$ of the explo-

ration field 4 assume values between a minimum value and a maximum value of the respective operational parameters ($V_{eq}$, $fs_w$, $I_L$). Specifically, therefore:

- $V_{eq}$ can vary between a minimum value $V_{eq,min}$ and a maximum value $V_{eq,max}$;
- $f_{sw}$ can vary between a minimum value $f_{sw,min}$ and a maximum value $f_{sw,max}$;
- $I_L$ can vary between a minimum value $I_{L,min}$ and a maximum value $I_{L,max}$; and
- $T_a$ can vary between a minimum value $T_{a,min}$ and a maximum value $T_{a,max}$.

Within the finite set of points $P_n$ that make up the exploration field 4 there will be, therefore, a point with minimum coordinates, for example given by ($V_{eq,min}$, $f_{sw,min}$, $I_{L,min}$) and a point of coordinates maximum, for example ($V_{eq,max}$, $f_{sw,max}$, $I_{L,max}$) at a given environmental temperature $T_a$.

The finite number of points $P_n$ included in the exploration field 4 is a function, for each of the exploration directions of the three-dimensional mathematical space 3, of:

- a number of samples ($N_{Veq}$, $N_{fsw}$, $N_{IL}$); and
- one offset ($\Delta V_{eq}$, $\Delta f_{sw}$, $\Delta I_L$) between one sample and the next one along the respective direction of exploration.

In other words, the number of samples ($N_{Veq}$, $N_{fsw}$, $N_{IL}$) and the offset ($\Delta V_{eq}$, $\Delta f_{sw}$, $\Delta I_L$) for each one of the three directions of exploration, determine the coordinates, within the mathematical space 3, of the points $P_n$ included in the exploration field 4.

Specifically, according to method 1 of the present invention, for each one of the three directions of exploration of the exploration field 4, the number of samples ($N_{Veq}$, $N_{fsw}$, $N_{IL}$) can be predetermined and the offset ($\Delta V_{eq}$, $\Delta f_{sw}$, $\Delta I_L$) can be also prefixed and constant, or the number of samples ($N_{Veq}$, $N_{fsw}$, $N_{IL}$) can be prefixed while the offset ($\Delta V_{eq,i}$, $\Delta f_{sw,j}$, $\Delta I_{L,k}$) with i = 1,..,$N_{Veq}$-1, j = 1,..,$N_{fsw}$-1, k = 1,..,$N_{IL}$-1, between two consecutive samples (corresponding to two consecutive points $P_{n-1}$ and $P_n$ of the exploration field 4) can vary, optionally according to a selection between a logarithmic, power, trigonometric, transcendent or predetermined numerical series function. According to a further variant of method 1 of the invention, the number of samples ($N_{Veq}$, $N_{fsw}$, $N_{IL}$) may not be predetermined and may depend on an offset ($\Delta V_{eq,i}$, $\Delta f_{sw,j}$, $\Delta I_{L,k}$) with i = 1, ..$N_{Veq}$-1, j = 1,..,$N_{fsw}$-1, k = 1,..,$N_{IL}$-1, that varies between one sample and the next one, which is calculated each time during the exploration of the exploration field 4, for each point $P_n$, optionally based on a value assumed by a set R of response parameters (which will be better described below), calculated at previously explored points $P_{n-1}$ and $P_{n-2}$ of the exploration field 4.

At the end of step B, the method 1 of the invention comprises at step C to explore the three-dimensional mathematical space 3, starting from a starting point included in the exploration field 4 defined as above, in search of points P of the three-dimensional mathematical space 3 that meet at least one working limit condition for inductor 2. As will be seen in detail below, the exploration of the three-dimensional mathematical space 3 takes by means of:

- the generation of at least one stimulus, determined based on the coordinates of points $P_n$ of the three-dimensional mathematical space 3 and based on the exploration field 4,
- the application of that stimulus to the inductor 2, and
- the detection of a correspondent response of said inductor 2 to said stimulus thereby applied. Based on the response thus detected, step C of invention method 1 also comprises determining and storing a finite subset of points $P^*_n$ of the three-dimensional mathematical space 3, among the points $P_n$ of the mathematical space for which the working limit condition of the inductor 2 is met.

More particularly, the exploration of the exploration field 4 is carried out in an orderly way (as will be better disclosed below), starting from one starting point $P_n$ of said exploration field 4, along the directions of exploration of the ordered set of directions for exploration and according to one exploration rule such that the coordinates of an explored n-th point $P_n$ of said three-dimensional mathematical space 3 differ from those of a previous point $P_{n-1}$, for the value of one or more of its components. Thus, for example:

- if the parameters of interest for an inductor to be examined are, in order $V_{eq}$, $f_{sw}$ and $I_L$;
- if in the three-dimensional mathematical space 3 a exploration field 4 is defined wherein $V_{eq}$ varies between $V_{eq,min}$ and $V_{eq,max}$, $f_{sw}$ varies between $f_{sw,min}$ and $f_{sw,max}$ and $I_L$ varies between $I_{L,min}$ and $I_{L,max}$;
- if the exploration field 4 is explored starting from a starting point $P_1$ having coordinates ($V_{eq,min}$, $f_{sw,min}$, $I_{L,min}$); and
- assuming that the offsets between one point and another of the exploration field 4 are constant and predetermined;

then the point $P_2$, subsequently explored according to method 1 of the present invention, can have one of the following coordinates ($V_{eq,min} \pm \Delta V_{eq}$, $f_{sw,min}$, $I_{L,min}$), if the exploration is along the first direction of exploration, or ($V_{eq,min}$,

$f_{sw,min} \pm \Delta f_{sw}$, $I_{L,min}$), if the exploration is along the second exploration direction, or ($V_{eq,min}$, $f_{sw,min}$, $I_{L,min} \pm \Delta I_L$), if the exploration is along the third direction of exploration. That is, as mentioned above, each point differs from the previous one by the value of only one component of its coordinates.

According to a variation of the method 1 of the present invention, the exploration of the exploration field 4 can also be performed according to a different exploration rule for which the coordinates of an n-th point $P_n$ differ from those of the previous point $P_{n-1}$, for the value assumed by two or all three components. For example, according to a variation of the method of the present invention, the exploration of the exploration field 4 can be performed over parallel planes wherein, then, the points $P_n$ of the exploration field 4, which lie on a plane parallel to the one on which two axes of three-dimensional mathematical space 3 lie, are first explored starting from a starting point of minimum coordinates (for example starting from $P_1$ having coordinates ($V_{eq,min}$, $f_{sw,min}$, $I_{L,min}$) until a point $P_n$ of maximum coordinates in that plane is reached (thus arriving at a point of coordinates ($V_{eq,max}$, $f_{sw,max}$, $I_{L,min}$) and then passing to the adjacent parallel plane and exploring this adjacent parallel plane starting from a point with minimum coordinates in that plane $P_{n+1}$= ($V_{eq,min}$, $f_{sw,min}$, $I_{L,min} + \Delta I_L$). It is understood that the one provided is a purely indicative and non-limiting example for the present invention and the person skilled in the art will have no difficulty in understanding how it is possible to explore the points of the exploration field 4 also in other ways, for example starting from a point of maximum coordinates for the field of exploration or in a plane thereof as described above.

With regard to the working limit condition, it is specified that whether or not that working limit condition is met in any point $P_n$ of the three-dimensional mathematical space 3 (including those of the exploration field 4) depends on the value assumed by at least one response parameter of the set R of response parameters of the inductor 2, following the application to its terminals of at least one stimulus as described above (i.e. comprising a square wave voltage $v_L(t)$ and an average current $I_L$), and by a pre-set search logic, as explained below.

The response parameters that are comprised in the above said set R are one or more between:

- a peak-to-peak variation ($\Delta i_{Lpp}$) of the current ($i_L(t)$) varying over time flowing through inductor 2;
- a surface temperature ($T_s$) of the inductor; and
- an average electrical power ($P_d$) dissipated by the inductor 2.

It should be noted that, according to a preferred embodiment of the invention, the aforementioned response parameters can be detected by a detecting device included in a measuring station which also forms part of the present invention, and which will be described below. More particularly, the peak-to-peak variation of the time-varying current($i_L(t)$) flowing through the inductor and the surface temperature $T_s$ can be directly detected by respective analog components of the detecting device, while the dissipated power $P_d$ can be calculated as a function of the stimulus variable voltage $v_L(t)$ applied to the inductor 2 and the variable current $i_L(t)$ detected by it. Alternatively, according to a variant of the present invention, the dissipated power $P_d$ can also be determined in an alternative way. For example, according to a variant of the present invention, the dissipated power $P_d$ can be determined in a more approximate but still reliable way, as a function of the surface temperature $T_s$ of the inductor 2, in a way known to the man skilled in the art.

According to method 1 of the invention, the aforementioned working limit condition for inductor 2 is a function of a threshold value ($\Delta i_{Lpp,ref}$, $T_{s,ref}$, $P_{d,ref}$) for a corresponding response parameter. More particularly, the working limit condition is met if one or more response parameters assume a value lower than or equal to the respective threshold value ($\Delta i_{Lpp,ref}$, $T_{s,ref}$, $P_{d,ref}$).

As far as the search logic is concerned, the working limit condition for the points P of the three-dimensional mathematical space 3 can concern, as mentioned above:

(i) only one response parameter of the set R of response parameters; or
(ii) jointly more than one of the response parameters of the set R of response parameters, as mentioned above, corresponding to the peak-to-peak value of the current oscillation $\Delta i_{Lpp}$, or the inductor surface temperature $T_s$, or the average electrical power $P_d$ dissipated by the inductor.

In other words, the exploration of three-dimensional mathematical space 3 can be carried out by considering three distinct working limit conditions according to the following different search logics:

1) a first search logic, according to which three distinct sets of points P of the three-dimensional mathematical space 3 are identified, each set complying with only one of the working limit condition;
2) a second search logic, according to which three distinct sets of points P of the three-dimensional mathematical space 3 are identified, each set complying with one among the possible pairs of working limit conditions;
3) a third search logic, according to which the set of points P of the three-dimensional mathematical space 3 is identified, the points jointly complying with all three working limit conditions.

According to an advantageous embodiment of the invention, the search logic is selected at step B or in any case before the execution of step C of invention method 1. Alternatively, the search logic can be pre-set.

Going into the merits of step C of method 1 of the present invention, it comprises:

C.1 selecting one starting point $P_n$ comprised in said exploration field 4 and one first direction of exploration of said exploration field 4;

C.2 generating, by means of a stimulus generation device (which will also be discussed below), one stimulus comprising a varying over time voltage $v_L(t)$ and a constant average current $I_L$, based on the value of the coordinates of the just selected point $P_n$, and applying the stimulus thus generated to inductor 2;

C.3 detecting at the terminals of inductor 2, by means of the detecting device, in response to the stimulus thus applied, at least one varying over time current $i_L(t)$ and the surface temperature of the inductor ($T_s$);

C.4 determining, through the data control and processing unit, said set R of response parameters, based on the corresponding detected varying over time current ($i_L(t)$) and the inductor surface temperature ($T_s$); and

C.5 comparing, through said data control and processing unit, each element of said set R of response parameters with said working limit condition; and

C.6 if said working limit condition is met at point $P_n$:

C.6.1 selecting a new point $P_n$ of the three-dimensional mathematical space 3, along the first selected direction of exploration; and

C.6.2 if the new point $P_n$ is comprised within the field of exploration 4, going back to step C.2;
Otherwise going to step C.8

C.7 if said working limit condition is not met at point $P_n$:

C.7.1 if the point $P_n$ just selected is the starting point of said exploration field 4:

C.7.1.1 selecting a new point $P_n$ of the three-dimensional mathematical space 3, along the first selected direction of exploration; and

C.7.1.2 if the new point $P_n$ is comprised within said exploration field 4:

C.7.1.2.1 carrying out steps C.2-C.5 and

C.7.1.2.2 if said working limit condition is not met in the new point $P_n$ of the three-dimensional mathematical space 3, going back to step C.7.1.1;
otherwise going back to step C.6

otherwise going to step C.8

otherwise

C.7.2 if the point $P_n$ just selected and the point $P_{n-1}$ previous to that are placed along the first direction of exploration:

C.7.2.1 determining, through the data control and processing unit, and storing, in a storage unit, the coordinates ($p^*_{n1}$, $p^*_{n2}$, $p^*_{n3}$) of another point $P^*_n$ of the three-dimensional space 3, that is comprised in the neighbourhood of point $P_n$ of said exploration field 4, along said first selected direction of exploration, wherein said working limit condition is met;

C.7.2.2 selecting previous point $P_{n-1}$ and, starting from that, a new point $P_n$, of the three-dimensional mathematical space 3 along the second direction of exploration; and

C.7.2.3 if the newly selected point $P_n$ is comprised within said exploration field 4, going back to step C.2;
otherwise going to step C.8

otherwise

C.7.3 if the point $P_n$ just selected and the point $P_{n-1}$ previous to that are placed along the second direction of exploration:

C.7.3.1 selecting a new point $P_n$ of the three-dimensional mathematical space 3, along the first direction of exploration; and

C.7.3.2 if the newly selected point $P_n$ is comprised within said exploration field 4, going back to step C.2;
otherwise, going to step C.8;

C.8 if the point $P_n$ just selected is not comprised within said exploration field 4:

> C.8.1 selecting, along the second direction of exploration, a new point $P_n$ of the three-dimensional mathematical space 3, starting from the previously selected point $P_{n-1}$ and, if the newly selected point $P_n$ is comprised within said exploration field 4, going back to step C.2; otherwise
> C.8.2 selecting, along the third direction of exploration, the new point $P_n$ of the three-dimensional mathematical space 3, starting from the previously selected point $P_{n-1}$ and, if the newly selected point $P_n$ is comprised within said exploration field 4, going back to step C.2; otherwise going to the following step (step D) which will be described below.

With particular reference to the above-mentioned step C.7.2.1, according to a preferred embodiment of method 1 of the present invention, it is envisaged that the stored coordinates of each point $P^*_n$ of the mathematical space 3, which is included in the neighbourhood of said point $P_n$ of the exploration field 4, can be calculated, by means of an interpolation formula, optionally a linear one. Specifically in the aforementioned case wherein:

- the parameters of interest for an inductor to be examined are, in order $V_{eq}$, $f_{sw}$ e $I_L$;
- in the three-dimensional mathematical space 3 a exploration field 4 is defined wherein $V_{eq}$ varies between $V_{eq,min}$ and $V_{eq,max}$, $f_{sw}$ varies between $f_{sw,min}$ and $f_{sw,max}$ and $I_L$ varies between $I_{L,min}$ and $I_{L,max}$;
- if that exploration field 4 is first explored along the first exploration direction, so that a previous point $P_{n-1}$ has coordinates $(V_{eq}[n-1], f_{sw}[n-1], I_L[n-1])$ and a point $P_n$ has coordinates $(V_{eq}[n-1]+ \Delta V_{eq}, f_{sw}[n-1], I_L[n-1])$, the coordinates of the new point $P^*_n$ to be stored $(V^*_{eq}, f_{sw}[n-1], I_L[n-1])$ are given by:

$$V^*_{eq} = \begin{cases} V_{eq}[n-1] + \dfrac{\Delta i_{Lpp,ref} - \Delta i_{Lpp}[n-1]}{\Delta i_{Lpp}[n] - \Delta i_{Lpp}[n-1]} \Delta V_{eq} & se\ \Delta i_{Lpp}[n] > \Delta i_{Lpp,ref} \\[3mm] V_{eq}[n-1] + \dfrac{P_{d,ref} - P_d[n-1]}{P_d[n] - P_d[n-1]} \Delta V_{eq} & se\ P_d[n] > P_{d,ref} \\[3mm] V_{eq}[n-1] + \dfrac{T_{s,ref} - T_s[n-1]}{T_s[n] - T_s[n-1]} \Delta V_{eq} & se\ T_s[n] > T_{s,ref} \end{cases}$$

depending on which of the response parameters of the set R of the response parameters does not comply with the limit condition.

Of course, if the exploration of the exploration field 4 was along the second or third direction of exploration, instead of $V_{eq}$ and $\Delta V_{eq}$, the above formula would involve, respectively, $f_{sw}$ with $\Delta f_{sw}$ and $I_L$ with $\Delta I_L$

Once the coordinates of a point $P^*_n$ have been determined, the above method 1 foresees, at step C.7.2.2, to select the previous point $P_{n-1}$ and, starting from this, a new point $P_n$ in the mathematical space 3 along the second exploration direction, where the coordinates of the new point are given by $(V_{eq}[n-1], f_{sw}[n-1]+ \Delta f_{sw}, I_L[n-1])$ or $((V_{eq}[n-1], f_{sw}[n-1]- \Delta f_{sw}, I_L[n-1])$ depending on the case. In fact, depending on which starting point is chosen, for the exploration of the exploration field 4, the values of the components of the coordinates of the points $P_n$ included therein will be increased or reduced, to allow the method of the present invention to explore and select the points of three-dimensional mathematical space 3, starting from those of the exploration field 4, which comply with the working limit condition.

At step C.7.3.1 of method 1 of the invention, on the other hand, a new point $P_n$ is selected in mathematical space 3 along the first direction of exploration, where the coordinates of the new point are determined starting from $P_n$ and are given by $(V_{eq}[n]]+ \Delta V_{eq}, f_{sw}[n], I_L[n])$ or $(V_{eq}[n] - \Delta V_{eq}, f_{sw}[n], I_L[n])$ depending on the case. In this case also, in fact, depending on which starting point is chosen, for the exploration of the exploration field 4, the values of the coordinates of the points $P_n$ included therein will be increased or reduced, to allow the method of the present invention to explore and select the points of three-dimensional mathematical space 3, starting from those of the exploration field 4, which comply with the working limit condition.

In other words, and as will also be seen in the following, the three-dimensional mathematical space 3 is explored, starting from the points of the exploration field 4, around its boundary surface which divides the three-dimensional mathematical space 3 into two half-spaces, one having points wherein the working limit condition is met and another having points wherein the working limit condition is not met.

The aforementioned step C.8 is about the case wherein a new selected point $P_n$ of the mathematical creation space 3 is not included in the exploration field 4 has, that is, wherein a component of its coordinates is outside the range of minimum and maximum values mentioned above, for example in the case wherein the exploration of the exploration field 4 is carried out along the first exploration direction and the new point $P_n$ has coordinates $(V_{eq,max}[n] + \Delta V_{eq}, f_{sw}[n], I_L[n])$. Method 1 of the present invention comprises selecting a new point $P_n$ of the three-dimensional mathematician, starting from this previously selected point $P_n$, along the second direction of exploration (step C.8.1) and, if this point $P_n$ is included in the field exploration, the method returns to step C.2; otherwise the method 1 of the invention comprises selecting the new point $P_n$ of the mathematical space, starting from the previously selected point $P_{n-1}$, along the third direction of exploration (step C.8.2) and, if the point direction of exploration is included in the exploration field 4, the method returns to step C.2. According to a further alternative, when the points $P_n$ of the exploration field 4, that are located around the boundary surface have all been explored, the method can continue to the next step (step D).

As anticipated above at step C.7.1 of the invention method, if during the execution of method 1 it is found, only for the initial point $P_n$ of the exploration field 4, that the working limit condition is not met, the method comprises searching for the first point $P_n$ of the exploration field 4 wherein the working limit condition is met, along the first direction of exploration. In other words, at the start of the invention method 1, the exploration field 4 is explored in search of a boundary point of the three-dimensional mathematical space 3, at which the inductor 2 has a behaviour that complies with the aforementioned working limit condition.

It should be noted that thanks to the guided exploration of the exploration field 4 at step C, the method 1 of the present invention allows selecting a finite number of points (or combinations of operational parameters) within the mathematical space 3, for which the inductor 2 complies with at least one limit condition (which typically corresponds to a threshold within which inductor 2 works in compliance with the working limit condition). The number of points of the exploration field 4 at which the exploration is actually carried out can be, depending on the case, much lower than the total number of points of the same exploration field 4, so that with the method 1 of the present invention the computational complexity required to determine the behaviour of inductor 2 is considerably reduced.

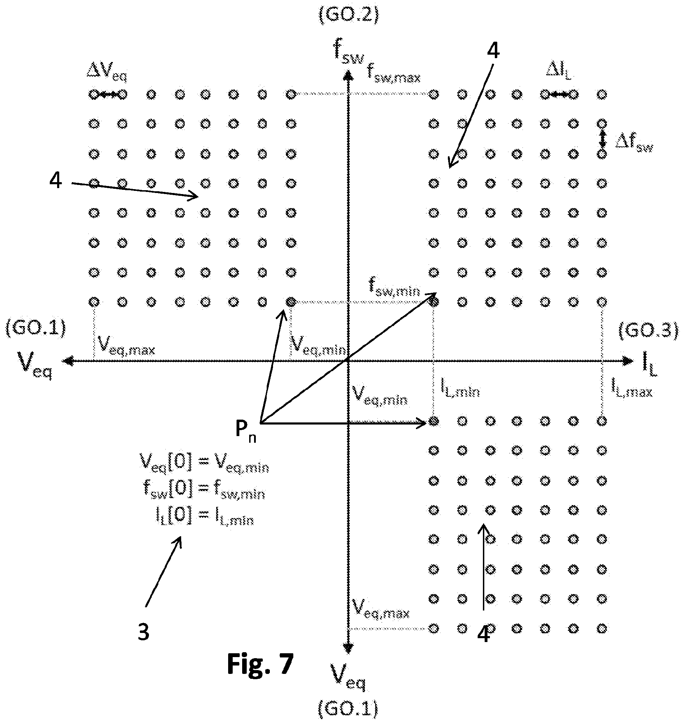

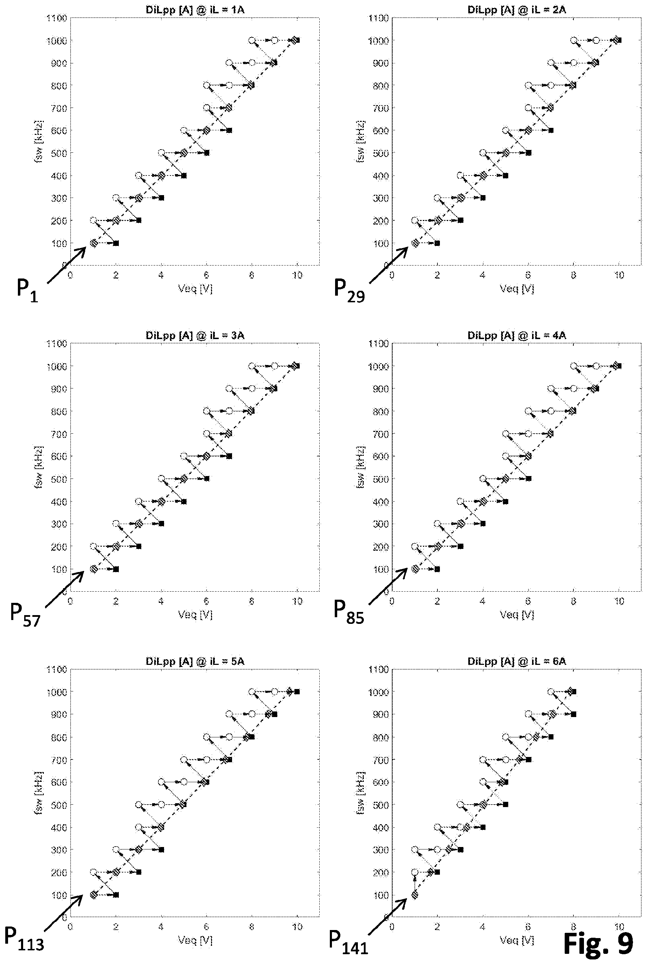

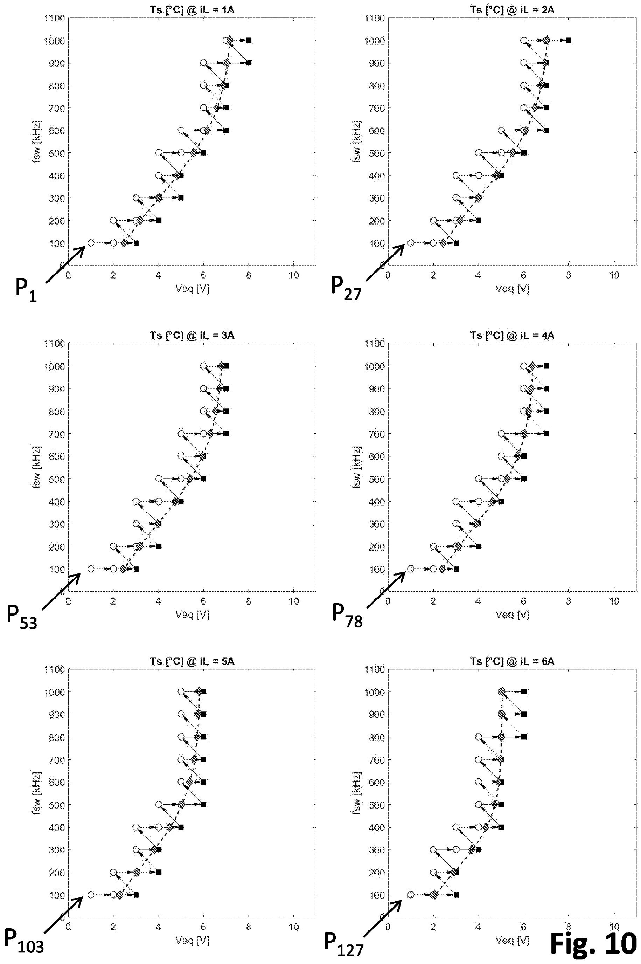

Purely by way of a non-limiting example, reference is made to Figures 7 to 10, wherein a search sequence carried out in the three-dimensional mathematical space 3 is illustrated, for a power inductor 2 having known characteristics, the fixed response conditions of which being:

- $\Delta i_{Lpp,ref}$=1.0 A;
- $T_{s,ref}$=120°C, and
- $P_{d,ref}$=200mW.

In the provided example, therefore, the three-dimensional mathematical space 3 is explored in search of the points $P^*_n$ (i.e., triples of operational parameters $V_{eq}$, $f_{sw}$, $i_L$) which constitute the boundary of the region (half-space) of the three-dimensional mathematical space 3, wherein the aforementioned predetermined working limit condition is valid.

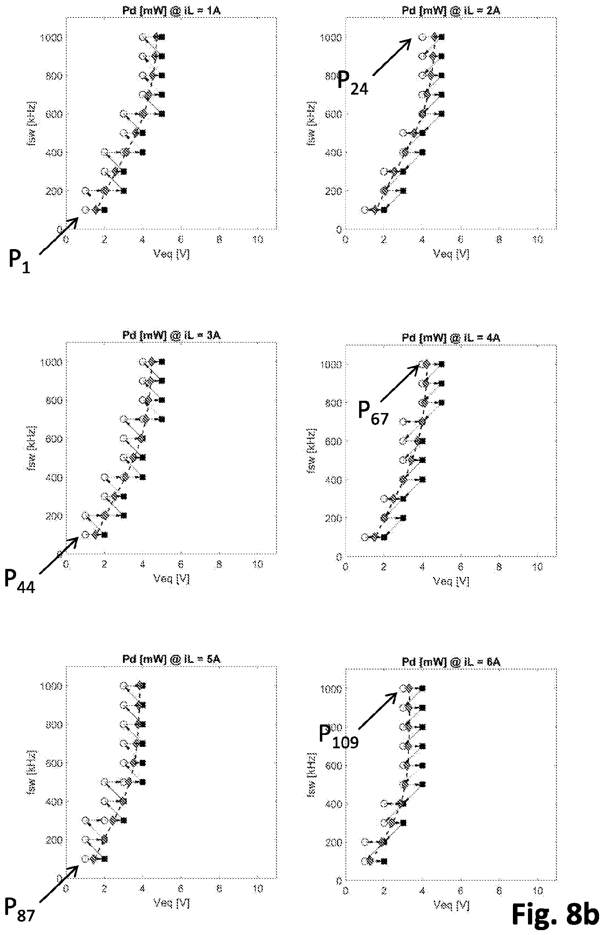

The operational parameters of interest are $V_{eq}$, $f_{sw}$ and $I_L$ and vary in the ranges $V_{eq,range}$ = [ 1V, 10V ], $f_{sw,range}$ = [ 100kHz, 1MHz ] and $I_{L,range}$ = [ 1A, 6A ], with uniform offsets of the operational quantities having amplitude equal to $\Delta V_{eq}$ = 1V, $\Delta f_{sw}$ = 100kHz, $\Delta I_L$ = 1A. The exploration field 4 is explored, in Figures 8b to 10, starting from starting point $P_1 = (V_{eq,min}, f_{sw,min}, I_{L,min})$ according to a first exploration direction parallel to the abscissa axis and a second direction of exploration parallel to the ordinate axis. The third direction of exploration is represented by the sequence of graphs where we go from $i_L$ =1A to $i_L$ = 6A.

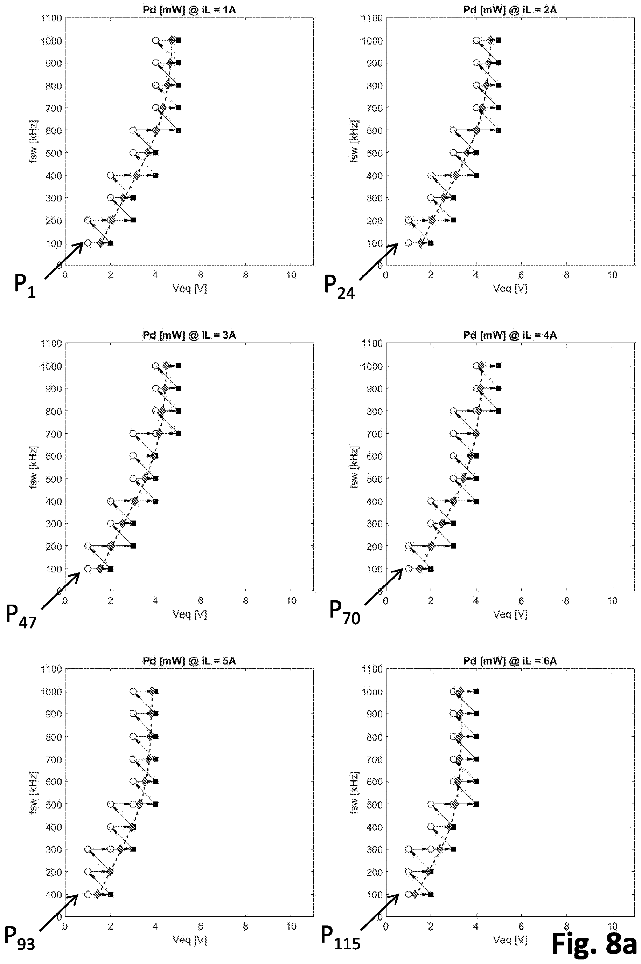

In the graphs illustrated at Figures 8a, 9 and 10:

- the dotted lines represent the actual operational limits of the component under investigation, corresponding to the above indicated set working limit conditions set,
- the white circles identify explored points $P_n$ of the exploration field 4, wherein the limit condition is met,
- the black squares identify explored points $P_n$ of the exploration field 4, wherein the working limit condition is not met,
- the grey rhombuses identify points $P^*_n$ of three-dimensional mathematical space 3 obtained through the interpolation formula above, which correspond to limit values of the operational parameter $V_{eq}$, given the values of the operational parameters $f_{sw}$ e $I_L$, at which the working limit condition is still met.

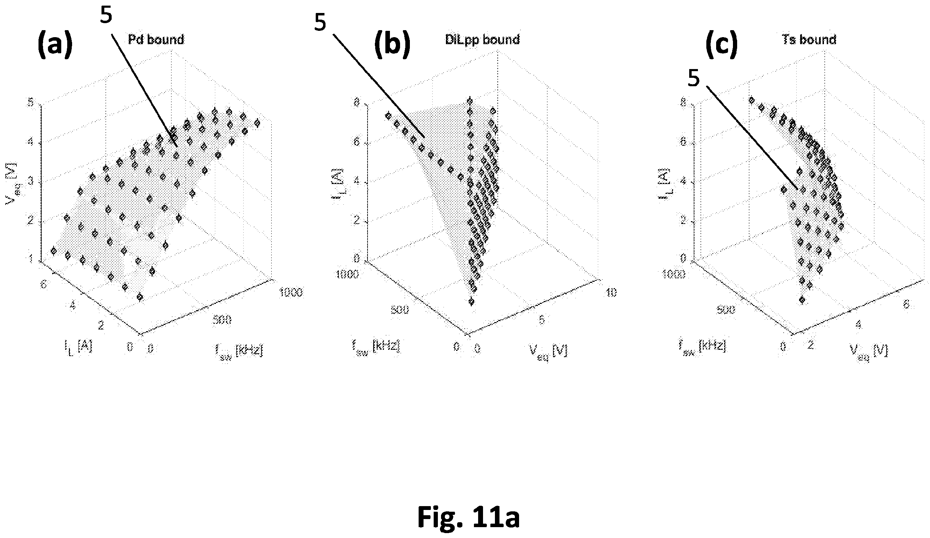

The result of the exploration is a list of coordinates of points $P^*_n$ of mathematical space 3 (corresponding to triplets of operational parameters for the inductor 2 of interest), wherein the working limit condition $\Delta i_{Lpp}=\Delta i_{Lpp,ref}$ and/or $T_s=T_{s,ref}$ e/o $P_d=P_{d,ref}$ in met. With reference to the example of Figures 8a-8b, 9 and 10, the aforementioned list of coordinates represents the operational parameters that determine an inductor response wherein the power dissipation is $P_d=P_{d,ref}$=200mW, a response of the inductor wherein the peak-to-peak current ripple is $\Delta i_{Lpp}=\Delta i_{Lpp,ref}$=1.0A and an inductor response wherein the surface temperature is $T_s=T_{s,ref}$=120°C, respectively, in the case where an environmental temperature is equal to 40 ° C. In other words, each search carried out with reference to a specific working limit condition (search logic referred to in point 1) above) generates a corresponding specific list of triplets. That list of triplets identifies a certain surface in the three-dimensional mathematical space 3 having axes $V_{eq}$, $f_{sw}$, $I_L$. Surfaces 5(a), 5(b) and 5(c) shown in Figure 11a identify the location of the grey rhombuses of Figure 8, Figure 9, and Figure 10, respectively. It is of note that in Figures 8a to 10, the arrows represented there, which connect the white circles, the black squares and the grey rhombuses to each other only provide for a visual indication of the order wherein the points of the three-dimensional mathematical space 3 are explored. In the example shown above, the exploration of the aforementioned points requires that within a single plane of three-dimensional mathematical space 3 (represented by one of the six frame of each Figure), only one of the coordinates varies at a time, along a single direction for exploration, as described above, between a selected point and the next one. When moving between one plane of mathematical space 3 and a plane adjacent thereto, it can be foreseen that the points of the exploration field 4 are always explored starting from the one with lower coordinates (closest to the origin of the axes - Figures 8a, 9 and 10). In this case, the values of all three coordinate components change between the last point of a plane and the first point of the adjacent plane. Alternatively, as illustrated in Figure 8b, it can be expected that, between the last point of one plane and the first point of the adjacent plane, only the value of a component of the coordinate's changes. In this case, as can be seen in Figure 8b, while in the frames on the left the arrows follow a substantially ascending path, in the right frames the arrows follow a substantially descending path.

The method 1 of the present invention after step C, comprise the execution of step D wherein a mathematical model is determined, for example by means of the data control and processing unit, in the three-dimensional mathematical space 3, the mathematical model describing in analytic form the locus of the points $P^*_n$ thus stored, thereby obtaining a locus 5 of the operational parameters which determine a response in the inductor 2 which compiles with the working limit condition.

What is obtained, therefore, is an analytical description of the surface 5 of the three-dimensional mathematical space 3 which surface divides this space into two half-spaces: a first half-space, which defines the operational conditions at which inductor 2 operates in compliance with the working limit condition, and another half-space opposite to the first half-space with respect to surface 5, which defines the operational conditions at which the inductor 2 does not operate in compliance with the working limit condition.

According to a particularly advantageous embodiment of the invention, step D of method 1 includes the application of at least one algorithm, for example of Genetic programming algorithm (J. R. Koza, Genetic Programming: On the Programming of Computers by Means of Natural Selection, MIT Press, Cambridge, 1992), to above mentioned points $P^*_n$ stored during the previous step. It is quite clear, in this regard, that more than one algorithm belonging to the Genetic programming family of algorithms can be used for the execution of step D of the method according to the present invention. For example, instead of a preferred algorithm that will be disclosed by way of non-limiting example in the following, a Cartesian Genetic Programming algorithm (J.F. Miller, Cartesian Genetic Programming, Springer, ISBN 978-3-642-17310-3) or, alternatively to this algorithm family, a Grammatical Evolution algorithm (C. Ryan, M. O'Neill, Michael, J.J. Collins, Handbook of Grammatical Evolution, Springer, ISBN 978-3-319-78717-6), can be used, provided that such an algorithm is able to obtain a mathematical model that analytically describes the locus of the stored $P^*n$ points and, therefore, a locus 5 of the operational parameters which determine a response in the inductor 2 compiling with the working limit condition.

With reference to Figures 8a to 10, at step D of method 1 of the present invention the aforementioned algorithm is applied to the points $P^*_n$ i.e., to the grey rhombuses of Figure 11a whose coordinates have been stored in the storage unit. According to a preferred example of method 1 of the present invention, the Genetic Programming algorithm allows to obtain a function that analytically describes the locus of the operational parameters that determine an inductor response characterized by a certain value of the peak-to-peak current ripple $\Delta i_{Lpp}=\Delta i_{Lpp,ref}$ and/or its surface temperature $T_s=T_{s,ref}$ and/or its dissipated power $P_d=P_{d,ref}$, starting from the varying over time response of inductor 2 (i.e. from the current $i_L(t)$) experimentally acquired through a hardware system which will be described below, which is also the subject of the invention.

Therefore, as already mentioned above, the method 1 of the invention does not require the exhaustive execution of experimental tests on an entire mathematical space or three-dimensional domain of the values of the operational quantities $\{V_{eq}, f_{sw}, I_L\}$, but only on a very reduce subset of their combinations. To provide an example, if the exploration field 4 included 10 samples for each of the operational quantities $\{V_{eq}, f_{sw}, I_L\}$, compared to 1000 possible combinations (points $P_n$), the method of the present invention would test about 200 points.

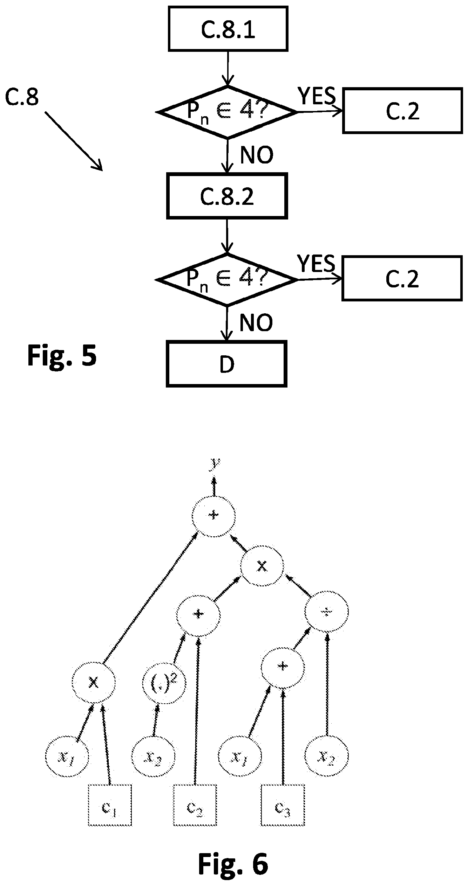

A Genetic Programming algorithm that can be advantageously used in the invention method 1 can be developed ad hoc or provided by software widely used in the field, for example MatLAB. Such an algorithm, as is known, adopts for the representation of a mathematical model a tree structure like the one shown, by way of example, in Figure 6 and described by the equation:

$$y = c_1 x_1 + (c_2 + x_2^2)\frac{x_1 + c_3}{x_2}$$

The tree that represents the mathematical model that is automatically generated by the Genetic Programming algorithm, providing as input a given set of elementary functions that operate on constant coefficients ($c_1$, $c_2$ e $c_3$) and independent variables ($x_1$ and $x_2$).

In the case of the present invention, the pair of input variables ($x_1$, $x_2$) can be associated, through the data control and processing unit referred to above, to any pair of the above operational parameters (($V_{eq}$, $f_{sw}$), ($f_{sw}$, $I_L$) or ($V_{eq}$, $I_L$), while the output can be associated with the remaining third operational parameter. The coefficients $c_1$, $c_2$, ... depend on the working limit condition of the inductor 2 under investigation, $\Delta i_{LPP} = \Delta i_{LPP,ref}$, or $T_s = T_{s,ref}$, or $P_d = P_{d,ref}$, for which the operational parameters triplet list has been generated, which describe a surface in the three-dimensional mathematical 3 space {$V_{eq}$, $f_{sw}$, $I_L$} identified by the combinations of operational parameters at which a limit condition is compiled with. It follows that the Genetic programming algorithm can generate nine different mathematical models, three for each inductor response parameter, as follows:

M.1. $V_{eq}$ model as a function of $f_{sw}$ and $I_L$ for a set $P_d$:

$$V_{eq} = f_{Veq,Pd}\left( f_{sw}, I_L, c_{Veq,1}(P_{d,ref}), c_{Veq,2}(P_{d,ref}),...\right)$$

M.2. $f_{sw}$ model as a function of $V_{eq}$ and $I_L$ for a set $P_d$:

$$f_{sw} = f_{fsw,Pd}\left( V_{eq}, I_L, c_{fsw,1}(P_{d,ref}), c_{fsw,2}(P_{d,ref}),...\right)$$

M.3. $I_L$ model as a function of $V_{eq}$ and $f_{sw}$ for a set $P_d$:

$$I_L = f_{IL,Pd}\left( V_{eq}, f_{sw}, c_{IL,1}(P_{d,ref}), c_{IL,2}(P_{d,ref}),...\right)$$

M.4. $V_{eq}$ model as a function of $f_{sw}$ and $I_L$ for a set $\Delta i_{Lpp}$:

$$V_{eq} = f_{Veq,\Delta iLpp}\left( f_{sw}, I_L, c_{Veq,1}(\Delta i_{Lpp,ref}), c_{Veq,2}(\Delta i_{Lpp,ref}),...\right)$$

M.5. $f_{sw}$ model as a function of $V_{eq}$ and $I_L$ for a set $\Delta i_{Lpp}$:

$$f_{sw} = f_{fsw,\Delta iLpp}\left( V_{eq}, I_L, c_{fsw,1}(\Delta i_{Lpp,ref}), c_{fsw,2}(\Delta i_{Lpp,ref}),...\right)$$

M.6. $I_L$ model as a function of $V_{eq}$ and $f_{sw}$ for a set $\Delta i_{Lpp}$:

$$I_L = f_{IL,\Delta iLpp}\left( V_{eq}, f_{sw}, c_{IL,1}(\Delta i_{Lpp,ref}), c_{IL,2}(\Delta i_{Lpp,ref}),...\right)$$

M.7. $V_{eq}$ model as a function of $f_{sw}$ and $I_L$ for a set $T_s$:

$$V_{eq} = f_{Veq,Ts}\left( f_{sw}, I_L, c_{Veq,1}(T_{s,ref}), c_{Veq,2}(T_{s,ref}),...\right)$$

M.8. $f_{sw}$ model as a function of $V_{eq}$ and $I_L$ for a set $T_s$:

$$f_{sw} = f_{fsw,Ts}\left( V_{eq}, I_L, c_{fsw,1}(T_{s,ref}), c_{fsw,2}(T_{s,ref}),...\right)$$

M.9. $I_L$ model as a function of $V_{eq}$ and $f_{sw}$ for a set $T_s$:

$$I_L = f_{IL,Ts}\left( V_{eq}, f_{sw}, c_{IL,1}(T_{s,ref}), c_{IL,2}(T_{s,ref}),...\right)$$

The coefficients and independent variables identify the terminal nodes of the tree. The elementary functions identify the non-terminal nodes of the tree. The independent variables are the inputs to the model. The model output is the result of the sequence of operations defined by the elementary functions. Table 1 reports an exemplary, non-limiting list of possible elementary functions. A complexity index is associated with each elementary function, as indicated in Table 1 by way of a non-limiting example. The input variables are assigned a complexity index of 1. The complexity of the model is obtained as follows:

- if a function is an argument of another function, then the complexity indices of the two functions are multiplied;
- if two functions are multiplied or added, then their complexity indices are added and the result is subsequently multiplied by the complexity index of the product or sum, respectively;

Tabella 1. Elementary functions

| #inputs | Non-terminal | Description | Complexity |
|---|---|---|---|
| 2 | sum | $f + g$ | 1 |
| 2 | multiplication | $f - g$ | 1 |
| 2 | power | $f^g$ | 1.5 |
| 2 | division | $f/g$ | 1.5 |
| 1 | logarithm | $\log(f)$ | 1.5 |
| 1 | natural exp. | $\exp(f)$ | 1,5 |
| 1 | power | $f^{\alpha}$ | 1.5 |
| 1 | exponential | $\alpha^f$ | 1.5 |
| 1 | square root | $\sqrt{f}$ | 1.5 |
| 1 | hyperbolic tangent | $\tanh(f)$ | 1.5 |
| 1 | inverse tangent | $\tan^{-1}(f)$ | 1.5. |
| 1 | reciprocal | $1/f$ | 1.5 |

The Genetic programming algorithm (J. R. Koza, Genetic Programming: On the Programming of Computers by Means of Natural Selection, MIT Press, Cambridge, 1992) which can be advantageously implemented in the method of the present invention, once the model to be generated (M.1, ..., M.9) has been determined, operates for example on a population of at least 100 models, optionally 500 models, which evolve over time over at least 100 generations, optionally 300 generations. Each model is a combination of elementary functions and coefficients, represented by a tree with a number of nodes not exceeding 100 nodes, optionally not exceeding 50 nodes. Starting from an initial population of models generated randomly, at each generation the precision with which each model reproduces the reference data is evaluated, and the population is then replaced by a new generation by applying a selection operator (in particular the *binary tournament* operator), of a cross-over operator (in particular the *subtree cross-over* operator) and of a mutation operator (in particular the *subtre&note mutation* operator), with equal cross-over probability of 80%, probability of subtree mutation equal to 18% and probability of node mutation equal to 2%.

The coefficients $c_x$ of the functions relating to the selected model can be determined, for the limit condition value $\{\Delta i_{Lpp,ref}, T_{s,ref}, P_{d,ref}\}$, for example through the Levenberg - Marquardt method, which identifies the best values of the coefficients, on the basis of the error minimization criterion $\chi^2$ applied to the $y_n$ values of the dependent variable of the selected model obtained in the dataset of the independent variables on n samples of the independent variables $(x_{1,i}, x_{2,i})$ i = 1, ..., n corresponding to the list of triplets obtained through the experimental tests. For example, in the case of model M.1 the error is expressed by the following formula:

$$X^2 = \frac{1}{n}\sum_{i=1}^{n}\left[f_{Veq,Pd}(f_{sw,i}, I_{L,i}) - V_{eq,i}\right]^2$$

where $V_{eq,i}$ is the experimental i-th value of the operative variable $V_{eq}$ corresponding to the i-th experimental values $f_{sw,i}$ e $I_{L,i}$ of the operational quantities $f_{sw}$ and $I_L$. The same formula applies to the remaining models M.2, ..., M.9.

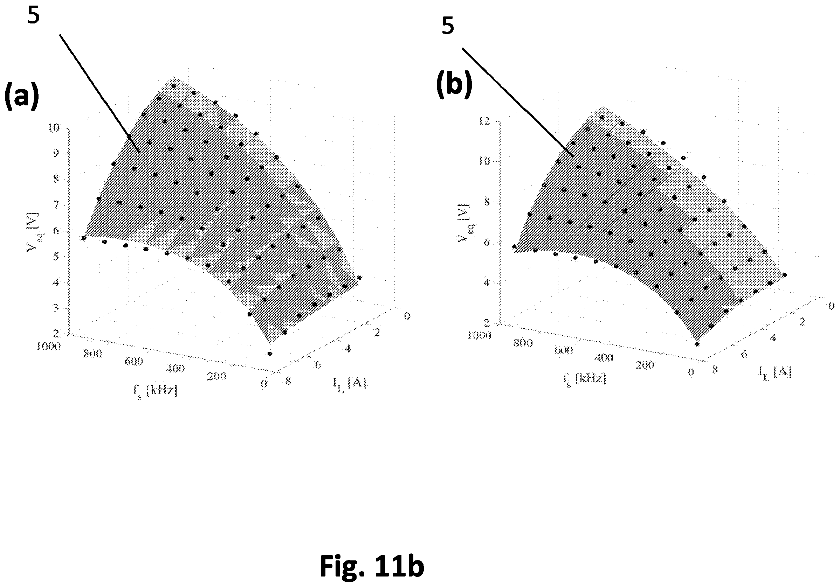

It is evident that the advantage of models M.1, ..., M.9 consists in the fact that they allow putting into relation the operational parameters of an inductor in a direct and simpler way than traditional methods and verifying whether or not they meet certain response conditions. For example, in the case of model M.1, given $V_{eq}$, $f_{sw}$ and $I_L$, and given the function $f_{Veq,Pd}(f_{sw}, I_L)$ corresponding to a certain $P_{d,ref}$, graphically represented by surface 5, if $V_{eq} < f_{Veq,Pd}(f_{sw}, I_L)$ then $P_d < P_{d,ref}$. Figure 11b shows some examples of functions generated by the algorithm above, based on model M.1, which describe in analytic form the locus of the operational parameters corresponding to surface 5 of Fig. 11a(a), that determine an inductor response that complies with the first limit condition, wherein in particular $P_d = P_{d,ref} = 200mW$;

The model obtained according to the method of the present invention (for example $f_{Veq,Pd}(f_{sw}, I_L)$) is defined on the samples of the surface it represents, for the identification of which few samples are sufficient, and which can be identified starting from the acquired experimental data limited to a neighbourhood thereof, in other words, without necessarily having to subject the inductor 2 to operational conditions which would determine a response very far from a limit operational condition of interest, of the type described above. It follows that, for the model obtained according to the method of the present invention, it is easier to obtain a good precision, since the model is valid on a portion restricted to a limited surface of the three-dimensional domain $\{[V_{eq,min}, V_{eq,max}], [f_{sw,min}, f_{sw,max}], [I_{L,min}, I_{L,max}]\}$.

The method 1 of the present invention can be advantageously implemented by a measuring station, indicated in Figures 12 to 17 with the reference 100, which is also the object of the present invention.

Such a measuring station 100, configured for the implementation of method 1 of the invention, includes:

- one data control and processing unit 101, configured for defining the three-dimensional mathematical space 3, the exploration field 4, the working limit condition, the set R of response parameters, and configured for comparing the set R with said working limit condition;
- a stimulus generation device 102, operatively connected to the data control and processing unit 101 and configured to generate at least one stimulus, comprising a time-varying voltage $v_L(t)$ and a constant current $I_L$, as a function of the value of the coordinates $(p_{n1}, p_{n2}, p_{n3})$ of the point $P_n$ selected in the explored three-dimensional mathematical space 3, and to apply the stimulus thus generated to inductor 2;

- a detecting device 103, operationally connected to the data control and processing unit 101 and configured to detect a varying over time current $i_L(t)$ across the inductor 2 as well as its surface temperature $T_s$, in response to the stimulus thus applied;
- at least one storage unit 104, operatively connected to said data control and processing unit 101 and configured for storing the coordinates of the points $P^*_n$ of the three-dimensional mathematical space 3 wherein the working limit condition is met;

wherein the data control and processing unit 101 is configured to be connected to at least one remote processing unit 200 and to send the coordinates of such $P^*_n$ points thereby stored, to this remote processing unit 200.

The remote processing unit 200 can in turn be configured to apply at least one algorithm, optionally a Genetic Programming algorithm, to the finite set of such points $P^*_n$ received by the measuring station 100 and output a description in analytical form of the locus of such points $P^*_n$, thus obtaining the locus 5 of the operational parameters which determine a response in the inductor 2 under investigation that complies with at least one working limit condition.

If desired, according to a preferred variant of the present invention, the data control and processing unit 101 can be physically distributed among several units, for example it can comprise a first data acquisition and control unit, optionally digital, indicated with the abbreviation UDAC in Figure 12, and another data connection unit, indicated by the abbreviation UDCD in Figure 12, also optionally digital, configured to connect the measuring station 100 according to the invention, for example to the remote processing unit 200 where it is physically performed the algorithm, optionally of Genetic Programming, which outputs the aforementioned description in analytical form of the locus of said stored $P^*n$ points.

According to a further variant of the measuring station 100 of the present invention, the data control and processing unit 101 can be configured to directly apply the above algorithm to the finite set of points stored in the storage 104, providing in output a description in analytical form of the locus of said points $P^*_n$ thus stored, and thus obtaining the locus 5 of the operational parameters which determine a response in the inductor 2 under investigation which comply with at least one working limit condition.

Not only that, the data control and processing unit 101 is configured to handle (through a firmware stored therein) steps A to C of method 1 of the present invention, namely:

- the determination of the points $P_n$ of the three-dimensional mathematical space 3 to be explored;
- the actuation of device 102 for the generation and application of the stimulus to inductor 2, based on the determined points $P_n$;
- the actuation of the detecting device 103, for detection of the varying over time current $i_L(t)$ of the inductor; and
- the calculation of all the parameters required for the implementation of such method.

According to a preferred embodiment of the measuring station 100 of the present invention, the stimulus generation device 102 is advantageously obtained through three power converting stages operatively connected in cascade according to the so-called Opposition Method (for example as taught in F. Forest et al., "Use of opposition method in the test of high-power electronic converters," in IEEE Transactions on Industrial Electronics, vol. 53, no. 2, pp. 530-541, April 2006), in order to subject inductor 2 under investigation to a stimulus corresponding to a triplet of the operational conditions described above.

The stimulus, as already mentioned in the introduction, comprises a zero mean square wave voltage, typical of hard-switching dc-dc PWM power converters, and a direct current, the characteristics of which, according to the present invention, are set by means of such converter stages.

More particularly, the three power converter stages comprise an Input Stage SdI, a Test Stage SdT and an Output Stage SdU, wherein the Test Stage SdT is connected between the Input Stage SdI and the Output stage SdU and is further configured to be connected to the inductor 2 to be investigated.

The Output Stage SdU is configured to operate in a closed loop and impose a direct current at the output of the Test Stage SdT, by adjusting its own average input current $I_o$: the SdU, therefore, operates as a variable direct current electrical load for SdT. The output of the Output Stage SdU is therefore connected to the input of the Test Stage SdT, so that the output current of SdU is returned to the input of SdT, so as not to make it strictly necessary, but optional, the inclusion of a power dissipating element (load EL in Figure 12), required to absorb the power that the SDT must deliver at the operational conditions to which the inductor 2 is subjected. In practice, this translates into a significant reduction in the power required for the operation of the measuring station.

As can be seen from Figure 12, therefore, according to a variant of the measuring station 100 of the invention, downstream of the Output Stage SdU, a switching element (Single Pole Double Throw or SPDT) of the output current can be provided, towards the SdT input or towards the external load EL, to allow in the latter case the measuring station 100 to operate even at different conditions, not foreseen in the case in which the Test Stage SdT is connected in a closed loop with the Output Stage.

The Input Stage SdI is configured to work in closed loop and provide in input to the Test Stage SdT one direct voltage, through adjustment of its output voltage $V_i$, and the Test stage SdT is configured to work in open loop and provide for the switching frequency of the varying over time zero mean square wave voltage $v_L(t)$, through adjustment of its own frequency $f_t$ and duty cycle Dt. In other words, the Test Stage modulates the direct voltage which is imposed by the Input Stage SdI with the direct current $I_L$ which is imposed on it by the Output stage SdU and therefore imposes to the terminals of the inductor 2 connected thereto the stimulus above described, comprising a varying over time square wave voltage $v_L(t)$ as described above and a direct current $I_L$.

The above adjustments are made based on specific control signals emitted by the data control and processing unit 101, according to a temporal sequence determined by an algorithm (firmware) which is stored in the data control and processing unit 101 or is supplied to it, by means of another processing unit, even a remote one (for example 200 in Figure 12). For example, as will also be seen below, the data control and processing unit 101, which can be optionally based on a micro controller, is configured to supply digital signals PWMi1, PWM2, PWMt and PWMu to stages SdI, SdT and SdU, based on analog reference values $V_{i,ref}$ e $I_{o,ref}$, $f_{t,ref}$ and $D_{t,ref,}$, received from the outside or from storage unit 104 and correlated to the coordinates of points $P^*_n$ previously stored therein, or from remote unit SI.

The detecting device 103 of the measuring station 100, according to a preferred variant of the invention represented in Figure 12, is integrated in the stimulus generation device 102 and is therefore also advantageously obtained through the Input Stage SdI, Test Stage SdT and Output Stage SdU. The detecting device 103 comprises respective sensors, configured to supply the actually measured signal of the input current $I_{o,mis}$ of the SdU (corresponding to the mean value $I_{L,av}$ of current $i_L(t)$ represented in Figure 1, for method 1) to the data control and processing unit 101 (more particularly to its acquisition and control unit UDAC) .

Not only that, those sensors are configured to send to the data control and processing unit 101 also a measured signal of the output voltage $V_{i,mis}$ of SdI (which is one of the elements that help define the voltage $v_L(t)$ of method 1 - in particular the component $V_{Lr}$ of $v_L(t)$ corresponds to the difference between Vi (output voltage of the SdI) and Vo (output voltage of SdT), while $V_{Lf}$ of $v_L(t)$ corresponds to the opposite of Vo (reference is always made to Figure 12) and of the frequency $f_{t,mis}$, duty cycle $D_{t,mis}$, peak-to-peak current $D_{iLppt,mis}$ and surface temperature $T_{s,mis}$ of the inductor 2 connected to the Test Stage SdT.

Those signals are produced by the analog conditioning circuits incorporated in the three stages SdI, SdT and SdU.

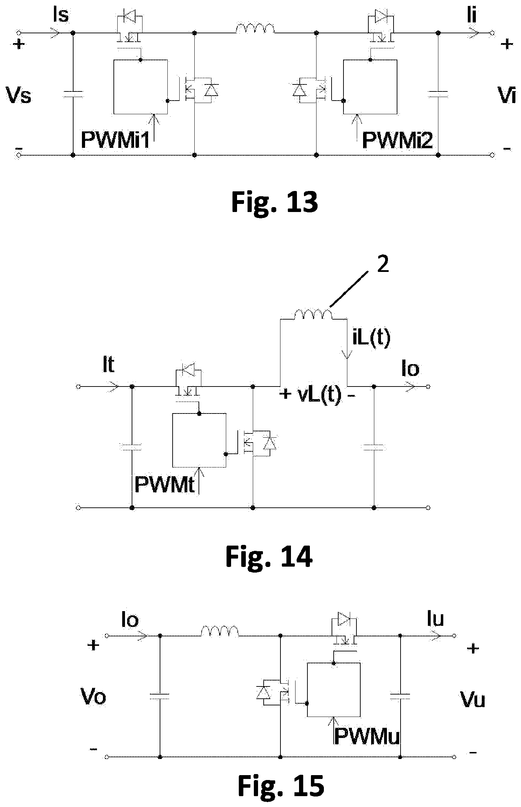

In this regard, the attached Figures 13 to 15 show preferred embodiments, given for illustrative and non-limiting purposes, of circuit implementations of the aforementioned three stages SdI, SdT and SdU.

As can be seen (Figure 13), the Input Stage SdI can be implemented by means of a noninverting step-up-down (buck-boost) DC-DC converter with four synchronous rectification switches. The SdI can use two distinct signals, PWMi1 and PWMi2, to control step-up and step-down operation, respectively. According to a preferred embodiment of the invention, during step-down operation, PWMi1 signal is active, the duty cycle Di1 of which being adjustable through a firmware implementing a first Digital Linear Controller (CLDi1), while PWMi2 signal is set to 0. Vice versa, during step-up operation, PWMi2 signal is active, the duty cycle Di2 of which being adjustable through a firmware that implements a second Digital Linear Controller (CLDi2), while PWMi1 signal is set to 1.

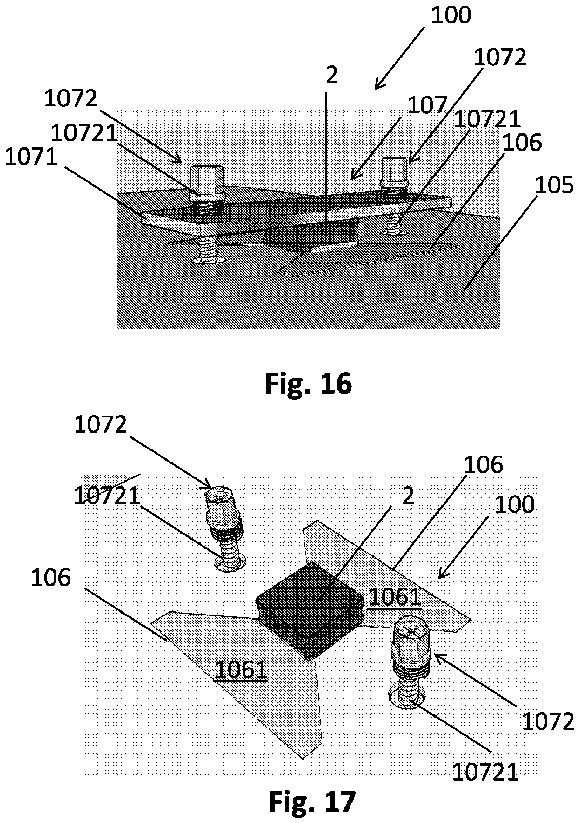

The Test Stage (Figure 14) can be implemented through a step-down (buck) DC-DC converter with synchronous rectification. According to a preferred embodiment of the measuring station 100 of the present invention, the Test stage comprises (see, in particular, Figures 16 and 17):

- a printed circuit 105 having conductive tracks 106, configured to provide the inductor 2 with the varying over time voltage $v_L(t)$ and the direct current $I_L$, wherein the conductive tracks 106 have at least one surface portion 1061, configured to enter electrically into contact with inductor 2; and
- a system 107 for positioning the inductor 2 on the printed circuit 105, wherein the inductor 2 is in electrical contact with the conductive tracks 106 of the printed circuit 105, without the need for welding.

In the measuring station 100 of the invention, the positioning system 107 comprises:

- one positioning plate 1071; and
- one group 1072 for the elastic anchoring of said positioning plate 1071 to said printed circuit 105.

The elastic anchoring group 1072 comprises one couple of elastically charged screws 10721, configured for being screwed on said printed circuit 105, passing through suitable openings obtained in said positioning plates 1071.
In this way, the inductor 2 is configured to be placed between the printed circuit 105 and the positioning plate 1071 and to be subjected to a pressure towards the conductive tracks 106 of the printed circuit 105, by means of the elastic anchoring group 1072 thus realizing with them an electrical contact.
On the positioning plate 1071 one of the aforementioned sensors (not shown in the drawings) is also provided, configured to detect and transmit the surface temperature $T_{s,mis}$ of the inductor 2 under investigation to the data control and processing unit 101.
As can be seen from the attached figures, the surface portion 1061 of the conductive tracks 106 has a polygonal configuration, optionally a trapezoidal one, which allows electrically and easily connecting inductors 2 of various sizes to the conductive tracks 106 of the measuring station 100, without the need for welding.
The advantages of this architecture, for the measuring station 100 of the present invention, are many. First of all, it does not require a dissipative load at the output of the SdU output stage and this therefore allows its dimensions to be reduced to a minimum. It also reduces the power that the Input Stage must deliver, equal to the sum of the losses of the SdT and SdU and allows the use of a low power AC / DC mains power supply (see Figure 12), for example a standard rectifier, which must in fact deliver a power equal to the sum of the losses of the three SdI, SdT and SdU stages.
Again, purely byway of non-limiting example, the aforementioned Input Stage SdI can be designed in such a way as to have:

- input voltage 24V DC or 220Vrms AC;
- continuous output voltage adjusted to a value between 12V and 48V;
- maximum output current 10A;
- efficiency at maximum current not less than 90%;
- overcurrent, overvoltage, open circuit, and short circuit protections;
- circuitry for measuring the value of the output voltage with a minimum precision of 1%.

The Test Stage SdT can be designed to have:

- input voltage between 12 V and 48 V;
- output voltage between 6 V and 42 V;
- maximum output current 10 A;
- maximum peak current of the inductor 20 A;
- duty-cycle comprised between 10% and 90%;
- switching frequency comprised between 100 kHz and 1 MHz;
- efficiency at maximum current not less than 90 %;
- overcurrent, overvoltage, open circuit, and short circuit protections;
- inductor connection system with no welding, with contacts at a distance between 2 mm and 2 cm and contact resistances not exceeding 10 m$\Omega$;
- circuitry for measuring the peak-to-peak current of the inductor with a minimum precision of 2%;
- circuitry for measuring the surface temperature of the inductor with a minimum precision of 1°C;
- circuitry for measuring the switching frequency with a minimum precision of 1 %;
- circuitry for measuring the duty-cycle with a minimum precision of 1 %.

The Output Stage SdU can be designed to have:

- input voltage between 6 V and 42 V;
- output voltage $\leq$ 48V;
- Adjustable input current between 0 and 10 A;
- maximum input current 10 A;
- efficiency at maximum current not less than 90 %;
- overcurrent, overvoltage, open circuit, and short circuit protections;
- circuitry for measuring the mean input current with a minimum precision of 1 %.

The measuring station 100 described above, according to a variant of the invention and as anticipated above, can be used in conjunction with a remote processing unit 200, in a system 1000 for the implementation of method 1 of the present invention.

In system 1000, some embodiments of which are represented purely by way of non-limiting example in Figures 11 to 13, the measuring station 100 and the remote processing unit 200 can be operationally connected through a data network, optionally via cable or wirelessly.

Such system 1000 is configured for carrying out the method 1 of the present invention on the power inductors 2 which operate in typical conditions of hard-switching dc-dc PWM power converters, according to a suitable sequence of operational parameters given by the invention method 1. System 1000, according to a preferred embodiment of the invention, comprises:

- one or more Measuring Stations (SM) 100, independent from one another;
- one or more remote processing unit (PC) 200; and
- one interfacing system (SI) for example via software, between the two.

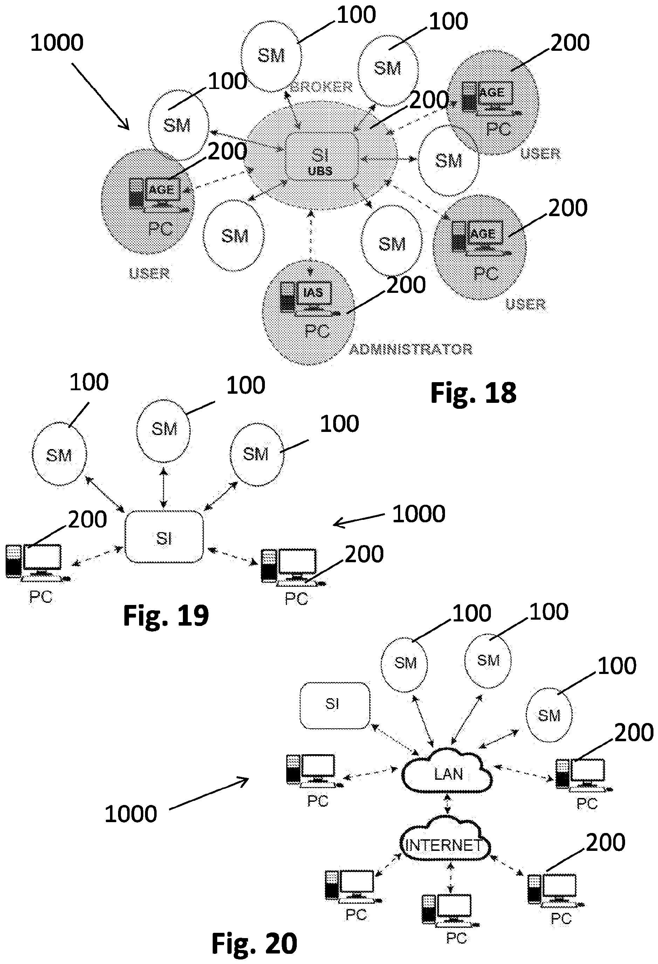

The architecture of system 1000 of the present invention is conceived as an open laboratory, which can be used by a single user or by a community of users and managed by an administrator. For this purpose, the software architecture can envisage three distinct types of remote processing units 200: one that operates as a System Administration (IAS), one that manages the actual execution of the measurement tests (AGE - the algorithm for determining the locus of the points of the three-dimensional mathematical space 3 that comply with the limit condition is physically executed on this unit) and a System Brokerage or Routing Unit (UBS), as illustrated in Figure 18.

According to a preferred embodiment of the invention, two operational modes are provided in system 1000:

- **Autonomous:** the measuring station 100 autonomously carries out the experimental tests. In this mode, before starting the tests, it will be necessary to send the measuring station 100 one file comprising a sequence to be used (optionally stored in the storage unit 104) for the generation of the stimuli and the relative parameters as well as the predetermined operational threshold conditions, etc. During the test session, the measuring station 100 will send the sampled data to the remote processing unit 200 with a frequency that can be programmed in the configuration step. It will be possible to interrupt the test session at any time, to change the algorithm and parameters sent, for example, by a user via the remote processing unit 200, and then restart the session with the newly set configuration.
- **Centralized:** the test session is completely managed by the remote processing unit 200. In this mode, the measuring station 100 just executes the commands sent by the remote processing unit 200 and transmits the results thereto, which are sampled at a frequency that is preprogrammed in the configuration step.

According to a further variant of the system 1000 of the present invention, this can work according to a:

- **Stand Alone modality:** in this modality the network of measuring stations 100 does not provide connection points with the outside and it is not necessary to have a network infrastructure in the operational environments (Figure 19).
- **Connected modality:** in this mode the system 1000 is connected to a network and the remote processing units 200 communicate with the system 1000 through this network. In the case wherein an internet connection is available at the operational site, the management and control of the system 1000 can be carried out also by using remote locations (Figure 20).

In view of the aforementioned description and the examples provided, the advantages offered by the method 1, the measuring station 100 and system 1000 of the present invention are clear.

In fact, thanks to method 1, the measuring station 100 and the system 1000 described above, it is possible to determine, quickly, with less computational effort than traditional methods, in a safe and reliable way, a function that describes in analytical form the locus 5 of the operational parameters (points $P^*_n$) of an electrical or electronic power component that respect the working limit condition, for example a value of the peak-to-peak current ripple $\Delta i_{Lpp} = \Delta i_{Lpp,ref}$, and/or its surface temperature $T_s = T_{s,ref}$, and/or its dissipated power $P_d = P_{d,ref}$.

The locus 5 of those operational parameters can be used by an operator, through the measuring station 100 or the system 1000 described above, to determine (for example visually by means of a display which can be operatively connected to such measuring station 100 or to a component of such system 1000) if starting from a triplet of operational parameters of the inductor under investigation, such inductor 2 complies or not with a limit condition. For example, according to a variant of the present invention, one or more mobile devices can be connected to the measuring station or system 1000, for example through the wifi, for displaying the results obtained by the method described above.

In the foregoing the preferred embodiments were described, and some modifications of the present invention were suggested, but it should be understood that those skilled in the art can make modifications and changes without departing from the relative scope of protection, as defined by the appended claims.

Thus, for example, as anticipated in the introduction, it is specified that although the present invention has been described with particular reference to power inductors, it is quite clear that it can also be applied to other electronic power components such as power capacitors, taking into account that where in this text reference is made to the voltage one should instead refer to the current and vice versa, and that where in this text reference is made to the inductance L one should instead refer to the capacitance C. In this case, the stimulus applied to the capacitor during step C.2 of method 1 would comprise a given square wave current ic(t), varying over time, and an average voltage $V_{C,av}$ and the response measured at step C.3 would comprise a varying over time voltage $v_C(t)$, detected at the terminals of the same capacitor. Similarly, based on the measured response, corresponding response parameters at step C.4 would be determined comprised between the voltage ripple $\Delta v_{Cpp}$, the surface temperature $T_s$ of the capacitor, and the average electrical power $P_d$ dissipated by the capacitor.

## Claims

1. Method (1) for determining the behaviour of one electrical or electronic power component (2), with respect to a working limit condition, the method comprising the following operational steps:

   A. defining one three-dimensional mathematical space (3) of operational parameters of interest for said electrical or electronic power component (2), wherein the coordinates of an n-th point $P_n$ of said three-dimensional mathematical space (3) correspond to specific values of said operational parameters of interest for said electrical or electronic power component (2);
   B. defining one exploration field (4) of said three-dimensional mathematical space (3), the working limit condition for said electrical or electronic power component (2) and one set R of response parameters of interest for said electrical or electronic power component (2);
   **characterised by** the following additional operational steps:
   C. exploring, said three-dimensional mathematical space (3) by:

   - generating at least one stimulus, determined based on the coordinates of the points $P_n$ of said three-dimensional mathematical space (3) and on said exploration field (4),
   - applying said at least one stimulus to said at least one electrical or electronic power component (2), and
   - detecting one corresponding response to said stimulus thereby applied, from said electrical or electronic power component (2), and

   based on said response thereby detected, determining, and storing one finite subset of points $P^*_n$ of said three-dimensional mathematical space (3), among the points $P_n$ of said three-dimensional mathematical space (3), for which said working limit condition of said electronic power component (2) is met; and
   D. determining one mathematical model that analytically describes the locus of said points $P^*_n$ of said three-dimensional mathematical space (3) thereby stored, thus obtaining the locus (5) of said operational parameters that determine a response of said electrical or electronic power component (2) that meets said working limit condition.

2. Method (1) according to claim 1, wherein said operational parameters of interest for said electrical or electronic power component (2) are selected among:

   - one equivalent voltage ($V_{eq}$) to be applied to said electrical or electronic power component (2);
   - one switching frequency ($f_{sw}$) for one entire charge-discharge cycle of said electrical or electronic power component (2);
   - one average current ($I_L$) flowing thorough said electrical or electronic power component (2); and
   - one temperature ($T_a$) of the environment wherein said electrical or electronic power component (2) is operational.

3. Method (1) according to claim 1 or 2, wherein said three-dimensional mathematical space (3) is defined by assigning to each one of said operational parameters of interest of said electrical or electronic power component (2), one corresponding mathematical axis of a Euclidean three-dimensional mathematical space.

4. Method (1) according to any previous claim, wherein said at least one exploration field (4) is defined by selecting:

   - one finite subset of points $P_n$ of said three-dimensional mathematical space (3); and
   - one ordered set of three directions of exploration of the points of said exploration field (4), starting from any point $P_{n-1}$ to a next point $P_n$, each direction of exploration being optionally parallel to a respective axis of said three-dimensional mathematical space (3).

5. Method according to claim 4, wherein the exploration of said three-dimensional mathematical space (3) is carried out, starting from one starting point $P_n$ of said exploration field (4), along said directions of exploration, in an orderly way, and according to one exploration rule such that the coordinates of an explored n-th point $P_n$ of said three-dimensional mathematical space (3) differ from those of a previous point $P_{n-1}$, for the value of one or more of its components.

6. Method according to claim 4 or 5, wherein the coordinates $(p_{n1}, p_{n2}, p_{n3})$ of points $P_n$ of said exploration field (4) have values comprised between one minimum value and one maximum value of respective operational parameters $(V_{eq}, f_{sw}, I_L)$ and wherein the finite number of said points $P_n$ of said exploration field (4) is a function, for each one of said directions of exploration of said three-dimensional mathematical space, of:

   - one number of samples $(NV_{eq}, Nf_{sw}, NI_L)$; and
   - one offset $(\Delta V_{eq}, \Delta f_{sw}, \Delta I_L)$ between one sample and the next one along the respective direction of exploration.

7. Method according to claim 6, wherein for each direction of said directions of exploration:

   - said number of samples $(NV_{eq}, Nf_{sw}, NI_L)$ is fixed, and said offset $(\Delta V_{eq}, \Delta f_{sw}, \Delta I_L)$ is fixed and constant; or
   - said number of samples $(NV_{eq}, Nf_{sw}, NI_L)$ is fixed, and said offset $(\Delta V_{eq,i}, \Delta f_{sw,j}, \Delta I_{L,k})$ varies between two subsequent samples, optionally according to one function selectable between a pre-set logarithmic, power, trigonometric, transcendent, or numerical series function; or
   - said number of samples $(NV_{eq}, Nf_{sw}, NI_L)$ depends on one offset $(\Delta V_{eq,i}, \Delta f_{sw,j}, \Delta I_{L,k})$ that is calculated, during said exploration of said exploration field (4), for each point $P_n$, optionally based on one value of one set R of response parameters, which response parameters are calculated at the last two points $P_{n-1}$ e $P_{n-2}$ explored in said exploration field (4).

8. Method (1) according to any previous claim, wherein the compliance or not of said working limit condition in any point $P_n$ of said three-dimensional mathematical space (3) depends on the value of at least one response parameter of said set R of response parameters of said electrical or electronic power component (2), the response parameters being determined based on the response detected from said electrical or electronic power component (2), after the application of said stimulus to its terminals, and on a pre-set search logic.

9. Method (1) according to claim 8, wherein said response parameter of said set R of response parameters of said electrical or electronic power component (2) is one among:

   - one peak-to-peak variation $(\Delta i_{Lpp})$ of a current $(i_L(t))$ that varies over time and flows through said electrical or electronic power component (2);
   - one surface temperature $(T_s)$ of said electrical or electronic power component (2);
   - one average electrical power $(P_d)$ dissipated by said electrical or electronic power component (2).

10. Method (1) according to claim 8 or 9, wherein said working limit condition of said electrical or electronic power component (2) is a function of a prefixed threshold value $(\Delta i_{Lpp,ref}, T_{s,ref}, P_{d,ref})$ for each response parameter.

11. Method (1) according to claim 10, wherein said at least one response parameter is compliant with said at least one working limit condition if its value is lower than or equal to a respective threshold value $(\Delta i_{Lpp,ref}, T_{s,ref}, P_{d,ref})$.

**12.** Method (1) according to any one of the preceding claims, wherein said step C comprises:

C.1 selecting, through a data control and processing unit (101), one starting point $P_n$ comprised in said exploration field (4) and one first direction of exploration of said exploration field (4);

C.2 generating, through one stimulus generating device, one stimulus comprising one varying overtime voltage $v_L(t)$ and one constant average current $I_L$, based on the value of the coordinates of said point $P_n$ just selected, and applying said stimulus thereby generated to the terminals of said electrical or electronic power component (2);

C.3 detecting at the terminals of said electrical or electronic power component (2), through one detecting device, in reply to said stimulus thereby applied, at least one corresponding current ($i_L(t)$) which varies over time and flows through said electrical or electronic power component (2), and one corresponding surface temperature ($T_s$);

C.4 determining, through said data control and processing unit (101), said set R of response parameters, based on said current ($i_L(t)$) and said surface temperature ($T_s$) thereby detected; and

C.5 comparing, through said data control and processing unit (101), each element of said set R of response parameters with said working limit condition; and

C.6 if said working limit condition is met at said point $P_n$:

C.6.1 selecting a new point $P_n$ of said three-dimensional mathematical space (3), along said first selected direction of exploration; and

C.6.2 if said point $P_n$ is comprised within said exploration field (4), going back to step C.2; otherwise going to step C.8

C.7 if said working limit condition is not met at said point $P_n$:

C.7.1 if said point $P_n$ just selected is the starting point of said exploration field (4):

C.7.1.1 selecting a new point $P_n$ of said three-dimensional mathematical space (3), along said first selected direction of exploration; and

C.7.1.2 if said new point $P_n$ is comprised within said exploration field (4):

C.7.1.2.1 carrying out steps C.2-C.5 and

C.7.1.2.2 if said working limit condition is not met in said new point $P_n$, going back to step C.7.1.1, otherwise, going back to step C.6;

otherwise going to step C.8

otherwise

C.7.2 if said point $P_n$ just selected and the point $P_{n-1}$ previous to that are located along said first direction of exploration:

C.7.2.1 determining, through said data control and processing unit (101), and storing, in a storage unit, the coordinates ($p^*_{n1}$, $p^*_{n2}$, $p^*_{n3}$) of another point $P^*_n$ of the three-dimensional space 3, that is comprised in the neighbourhood of said point $P_n$ of said exploration field (4), along said first selected direction of exploration, wherein said working limit condition is met;

C.7.2.2 selecting the point $P_{n-1}$ previous to said $P_n$ and, starting from that, a new point $P_n$, along the second direction of exploration; and

C.7.2.3 if said newly selected point $P_n$ is comprised within said exploration field (4), going back to step C.2;

otherwise going to step C.8

otherwise

C.7.3 if said point $P_n$ just selected and the point $P_{n-1}$ previous to that are placed along the second direction of exploration:

C.7.3.1 selecting a new point $P_n$ of the three-dimensional mathematical space (3), along the first selected direction of exploration; and

C.7.3.2 if said newly selected point $P_n$ is comprised within said exploration field (4), going back to step C.2;

otherwise going to step C.8

C.8 if said point $P_n$ just selected is not comprised within said exploration field (4):

> C.8.1 selecting, along said second direction of exploration, a new point $P_n$ of the three-dimensional mathematical space (3), starting from the previously selected point $P_{n-1}$ and, if the newly selected point $P_n$ is comprised within said exploration field (4), going back to step C.2; otherwise
> C.8.2 selecting, along said third direction of exploration, a new point $P_n$ of the three-dimensional mathematical space (3), starting from the previously selected point $P_{n-1}$ and, if the newly selected point $P_n$ is comprised within said exploration field (4), going back to step C.2; otherwise going to said step D of said method.

13. Method (1) according to claim 12, wherein the stored coordinates of said point $P^*_n$ of said mathematical space (3), which point is comprised in the neighbourhood of said point $P_n$ of said exploration field (4), are calculated through an interpolation formula, optionally a linear one.

14. Method (1) according to any previous claim, wherein said step D comprises applying to said points $P^*_n$ of said mathematical space (3) thereby stored, through said data control and processing unit (101), at least one Genetic Programming or Grammatical Evolution algorithm.

15. Measuring station (100), configured for implementing the method (1) for determining the behaviour of an electrical or electronic power component (2) according to any previous claim, comprising:

> - one data control and processing unit (101), configured for defining said three-dimensional mathematical space (3), said exploration field (4), said working limit condition, said set R of response parameters, and for comparing each element of said set R, determined for the explored points of said three-dimensional mathematical space (3), with said working limit condition;
> - one stimulus generating device (102), operatively connected to said data control and processing unit (101) and configured for generating at least one stimulus, the stimulus comprising at least one zero mean and square wave voltage $v_L(t)$ and one constant average current $I_L$ for said electrical or electronic power component (2), based on the value of the coordinates of said point $P_n$ of said three-dimensional mathematical space (3), said coordinates being associated to respective values of said operational parameters ($V_{eq}$, $fs_w$, $I_L$) of said electrical or electronic power component (2), and for applying said stimulus thereby generated to said electrical or electronic power component (2);
> - one detecting device (103), operatively connected to said data control and processing unit (101) and configured for detecting said at least one varying over time current $i_L(t)$ and one surface temperature $T_s$ of said electrical or electronic power component (2), in reply to said stimulus thereby applied;
> - at least one storage unit (104), operatively connected to said data control and processing unit (101) and configured for storing the coordinates of the points $P^*_n$ of said mathematical space (3) wherein said working limit condition is met;

wherein said data control and processing unit (101) is configured for applying to said coordinates of said points $P^*_n$ thereby stored, at least one mathematical algorithm, optionally a Genetic Programming or Grammatical Evolution algorithm, said at least one mathematical algorithm providing for in output a description, in analytical form, of the locus of said points $P^*_n$, and thus the locus (5) of the corresponding operational parameters that determine a response from said electrical or electronic power component (2) that meets said at least one working limit condition.

16. Measuring station (100), according to claim 15, wherein said one stimulus generating device (102) and said detecting device (103) are obtained through three power converter stages operatively connected in cascade according to an Opposition Method, so as to:

> - subject said at least one electrical or electronic power component (2) to said at least one stimulus, based on the value of the coordinates of said point $P_n$; and
> - detect at least one varying over time current $i_L(t)$ and one surface temperature $T_s$ of said electrical or electronic power component (2).

17. Measuring station (100) according to claim 15 or 16, wherein said three converters comprise an Input Stage (SdI), a Test Stage (SdT) and an Output Stage (SdU), wherein the Test Stage (SdT) is connected between the Input Stage (SdI) and the Output stage (SdT) and is further configured to be connected to said electrical or electronic power component (2).

**18.** Measuring station (100) according to claim 17, comprising downstream of said Output Stage (SdU) one switching element (SPDT) of the current output from said Output Stage (SdU), toward the input of the Test Stage (SdT) or an external load (EL).

**19.** Measuring station (100) according to claim 17 or 18, wherein said Input Stage (SdI) is configured to work in closed loop and provide in input to said Test Stage (SdT) one direct voltage, through adjustment of the output voltage ($V_i$) thereof, and said Test stage (SdT) is configured to work in open loop and provide for a switching frequency of said zero mean and square wave voltage $v_L(t)$, through adjustment of its own frequency ($f_t$) and duty cycle ($D_t$).

**20.** Measuring station (100) according to any claim 17 to 19, wherein said Output stage (SdU) is configured to operate in closed loop and impose at the output of said Test Stage (SdT) a direct current, through adjustment of its own input average current.

**21.** Measuring station (100) according to any claim 15 to 20, comprising:

- one printed circuit (105) having conductive paths (106), configured for imposing said stimulus to said electrical or electronic power component (2), wherein said conductive paths (106) have at least one surface portion (1061) configured for electrically entering into contact with said electrical or electronic power component (2); and
- one positioning system (107) for said electrical or electronic power component (2) on said printed circuit (105), wherein said electrical or electronic power component (2) is in electrical contact with said conductive paths (106) of said printed circuit (105), without need for welds.

**22.** Measuring station (100) according to claim 21, wherein said positioning system (107) comprises:

- one positioning plate (1071); and
- one group (1072) for the elastic anchoring of said positioning plate (1071) to said printed circuit (105);

said electrical or electronic power component (2) being configured for being placed between said printed circuit (105) and said positioning plate (1071) and being subjected to one pressure toward said conductive paths (106) of said printed circuit (105), through said elastic anchoring group (1072).

**23.** Measuring station (100) according to claim 22 wherein said elastic anchoring group (1072) comprises one couple of elastically charged screws (10721), configured for being screwed on said printed circuit, passing through suitable openings obtained in said positioning plates (1071).

**24.** Measuring station (100) according to any claim 21 to 23, wherein said conductive paths (106) have a polygonal, optionally trapezoidal configuration.

**25.** Measuring station (100) according to any claim 21 to 24 wherein said detecting device (103) comprises at least one temperature sensor, operatively connected to said data control and processing unit (101) and configured for detecting said surface temperature ($T_s$) of said electrical or electronic power component (2) and for transmitting it to said data control and processing unit (101).

**26.** System (1000) for implementing the method (1) for determining the behaviour of an electrical or electronic power component (2) according to any previous claim, comprising at least one measuring station (100) according to any claim 15 to 25 and at least one remote processing unit (200), wherein said measuring station (100) and said remote processing unit (200) are operatively connected to each other, optionally through one network, optionally through one cable or wirelessly, and wherein said data control and processing unit (101) of said measuring station (100) is configured to send to said at least one remote processing unit (200) said coordinates of said points $P^*_n$ thereby stored, and said at least one remote processing unit (200) is configured to apply at least one mathematical algorithm, optionally a Genetic Programming or Grammatical Evolution algorithm, providing for in output a description, in analytical form, of the locus of said points $P^*_n$, and therefore the locus (5) of the corresponding operational parameters that determine a response from said electrical or electronic power component (2) that meets at least one working limit condition.

**Patentansprüche**

1.  Verfahren (1) zur Bestimmung des Verhaltens eines elektrischen oder elektronischen Leistungsbauteils (2) in Bezug auf einen Arbeitsgrenzzustand, wobei das Verfahren die folgenden Arbeitsschritte umfasst:

    A. Definieren eines dreidimensionalen mathematischen Raums (3) von Betriebsparametern, die für das elektrische oder elektronische Leistungsbauteil (2) von Interesse sind, wobei die Koordinaten eines n-ten Punktes P des dreidimensionalen mathematischen Raums (3) spezifischen Werten der Betriebsparameter entsprechen, die für das elektrische oder elektronische Leistungsbauteil (2) von Interesse sind;
    B. Definieren eines Erkundungsfeldes (4) des dreidimensionalen mathematischen Raums (3), der Arbeitsgrenzbedingung für das elektrische oder elektronische Leistungsbauteil (2) und eines Satzes R von interessierenden Antwortparametern für das elektrische oder elektronische Leistungsbauteil (2);
    **gekennzeichnet durch** die folgenden zusätzlichen Arbeitsschritte:
    C. untersuchen des dreidimensionalen mathematischen Raumes (3) **durch**:

    - Erzeugung mindestens einer Anregung, der auf der Grundlage der Koordinaten der Punkte Pn des dreidimensionalen mathematischen Raums (3) und des Erkundungsfelds (4) bestimmt wird,
    - Anwendung des mindestens einen Anregung auf das mindestens eine elektrische oder elektronische Leistungsbauteil (2) und
    - Erfassen einer entsprechenden Reaktion auf die **dadurch** angelegte Anregung von dem elektrischen oder elektronischen Leistungsbauteil (2), und

    Bestimmen und Speichern einer endlichen Untermenge von Punkten $P^*_n$ des dreidimensionalen mathematischen Raums (3) unter den Punkten $P_n$ des dreidimensionalen mathematischen Raums (3), für die die Arbeitsgrenzbedingung das elektronischen Leistungsbauteil (2) erfüllt ist, basierend auf der **dadurch** erfassten Antwort; und
    D. Bestimmen eines mathematischen Modells, das den Ort der Punkte $P^*_n$ des dreidimensionalen mathematischen Raums (3) analytisch beschreibt, der auf diese Weise gespeichert wird, um so den Ort (5) der Betriebsparameter zu erhalten, die eine Reaktion des elektrischen oder elektronischen Leistungsbauteils (2) bestimmen, die die Arbeitsgrenzbedingung erfüllt.

2.  Verfahren (1) nach Anspruch 1, wobei die interessierenden Betriebsparameter für das elektrische oder elektronische Leistungsbauteil (2) ausgewählt werden aus:

    eine Ersatzspannung ($V_{eq}$), die an das elektrische oder elektronische Leistungsbauteil (2) anzulegen ist;

    - eine Schaltfrequenz ($f_{sw}$) für einen gesamten Lade-Entlade-Zyklus des elektrischen oder elektronischen Leistungsbauteils (2);

    einen durchschnittlichen Strom ($I_L$), der durch das elektrische oder elektronische Leistungsbauteil (2) fließt; und

    - eine Temperatur ($T_a$) der Umgebung, in der das elektrische oder elektronische Leistungsbauteil (2) in Betrieb ist.

3.  Verfahren (1) nach Anspruch 1 oder 2, wobei der dreidimensionale mathematische Raum (3) definiert wird, indem jedem der interessierenden Betriebsparameter des elektrischen oder elektronischen Leistungsbauteils (2) eine entsprechende mathematische Achse eines euklidischen dreidimensionalen mathematischen Raums zugewiesen wird.

4.  Verfahren (1) nach einem der vorhergehenden Ansprüche, wobei das mindestens eine Erkundungsfeld (4) durch Auswahl definiert wird:

    eine endliche Untermenge von Punkten $P_n$ des dreidimensionalen mathematischen Raums (3); und
    eine geordnete Menge von drei Erkundungsrichtungen der Punkte des Erkundungsfeldes (4), ausgehend von einem beliebigen Punkt $P_{n-1}$ zu einem nächsten Punkt $P_n$, wobei jede Erkundungsrichtung gegebenenfalls parallel zu einer entsprechenden Achse des dreidimensionalen mathematischen Raums (3) verläuft.

5.  Verfahren nach Anspruch 4, bei dem die Erkundung des dreidimensionalen mathematischen Raums (3) ausgehend

von einem Startpunkt $P_n$ des Erkundungsfelds (4) entlang der Erkundungsrichtungen in geordneter Weise und gemäß einer Erkundungsregel derart durchgeführt wird, dass sich die Koordinaten eines erkundeten n-ten Punkts $P_n$ des dreidimensionalen mathematischen Raums (3) von denen eines vorherigen Punkts $P_{n-1}$ für den Wert einer oder mehrerer seiner Komponenten unterscheiden.

6. Verfahren nach Anspruch 4 oder 5, bei dem die Koordinaten $(p_{n1}, p_{n2}, p_{n3})$ der Punkte $P_n$ des Erkundungsfeldes (4) Werte aufweisen, die zwischen einem Minimalwert und einem Maximalwert der jeweiligen Betriebsparameter $(V_{eq}, f_{sw}, I_L)$ liegen, und bei dem die endliche Anzahl der Punkte P des Erkundungsfeldes (4) für jede der Erkundungsrichtungen des dreidimensionalen mathematischen Raumes eine Funktion ist von:

   - eine Anzahl von Stichproben $(NV_{eq}, Nf_{sw}, NI_L)$; und
   - einen Versatz $(\Delta V_{eq}, \Delta f_{sw}, \Delta I_L)$ zwischen einer Probe und der nächsten entlang der jeweiligen Erkundungsrichtung.

7. Verfahren nach Anspruch 6, bei dem für jede Richtung der genannten Erkundungsrichtungen:

   die Anzahl der Proben $(NV_{eq}, Nf_{sw}, NI_L)$ fest ist und der Offset $(\Delta V_{eq}, \Delta f_{sw}, \Delta I_L)$ fest und konstant ist; oder
   die Anzahl der Proben $(NV_{eq}, Nf_{sw}, NI_L)$ ist fest, und der Offset $(\Delta V_{eq,i}, \Delta f_{sw,j}, \Delta I_{L,k})$ zwischen zwei aufeinanderfolgenden Abtastwerten variiert, wahlweise entsprechend einer Funktion, die aus einer vorgegebenen logarithmischen, Potenz-, trigonometrischen, transzendenten oder
   numerischen Reihenfunktion ausgewählt werden kann; oder

   - die Anzahl der Proben $(NV_{eq}, Nf_{sw}, NI_L)$ von einem Offset $(\Delta V_{eq,i}, \Delta f_{sw,j}, \Delta I_{L,k})$ abhängt, der während der Erkundung des Erkundungsfeldes (4) für jeden Punkt $P_n$ gegebenenfalls auf der Grundlage eines Wertes eines Satzes R von Antwortparametern berechnet wird, wobei die Antwortparameter an den beiden letzten in dem Erkundungsfeld (4) erkundeten Punkten $P_{n-1}$ ; $P_{n-2}$ berechnet werden.

8. Verfahren (1) nach einem der vorhergehenden Ansprüche, bei dem die Einhaltung oder Nichteinhaltung der Arbeitsgrenzbedingung in einem beliebigen Punkt $P_n$ des dreidimensionalen mathematischen Raums (3) vom Wert mindestens eines Antwortparameters des Satzes R von Antwortparametern des elektrischen oder elektronischen Leistungsbauteils (2) abhängt, wobei die Antwortparameter auf der Grundlage der von des elektrischen oder elektronischen Leistungsbauteils (2) nach dem Anlegen der Anregung an ihre Anschlüsse erfassten Antwort und einer voreingestellten Suchlogik bestimmt werden.

9. Verfahren (1) nach Anspruch 8, wobei der Ansprechparameter des Satzes R von Ansprechparametern des elektrischen oder elektronischen Leistungsbauteils (2) einer der folgenden ist:

   - eine Spitze-Spitze-Schwankung $(i\Delta_{Lpp})$ eines Stroms $(i_L(t))$, der sich im Laufe der Zeit ändert und durch das elektrische oder elektronische Leistungsbauteil (2) fließt;
   - eine Oberflächentemperatur $(T_S)$ des elektrischen oder elektronischen Leistungsbauteils (2);
   - eine durchschnittliche elektrische Leistung $(P_d)$, die von dem elektrischen oder elektronischen Leistungsbauteil (2) abgegeben wird.

10. Verfahren (1) nach Anspruch 8 oder 9, wobei die Arbeitsgrenzbedingung des elektrischen oder elektronischen Leistungsbauteils (2) eine Funktion eines vordefinierten Schwellenwerts $(\Delta i_{Lpp,ref}, T_{s,ref}, P_{d,ref})$ für jeden Reaktionsparameter ist.

11. Verfahren (1) nach Anspruch 10, wobei der mindestens eine Antwortparameter mit der mindestens einen Arbeitsgrenzbedingung übereinstimmt, wenn sein Wert kleiner oder gleich einem entsprechenden Schwellenwert $(\Delta i_{Lpp,ref}, T_{s,ref}, P_{d,ref})$ ist

12. Verfahren (1) nach einem der vorhergehenden Ansprüche, wobei der Schritt C umfasst:

   C.1 Auswahl eines Startpunktes $P_n$ durch eine Datensteuerungs- und-verarbeitungseinheit (101) die in dem Erkundungsfeld (4) enthalten sind, und eine erste Erkundungsrichtung des Erkundungsfeldes (4);
   C.2 Erzeugen einer Anregung durch eine Anregung -Erzeugungsvorrichtung, der eine über die Zeit variierende Spannung $v_L(t)$ und einen konstanten Durchschnittsstrom $I_L$ umfasst, basierend auf dem Wert der Koordinaten des soeben ausgewählten Punktes $P_n$, und Anlegen der so erzeugten Anregung an die Klemmen des elektrischen oder elektronischen Leistungsbauteils (2);

C.3 Erfassen an den Anschlüssen des elektrischen oder elektronischen Leistungsbauteils (2) durch eine Erfassungsvorrichtung als Antwort auf die dadurch angelegte Anregung mindestens einen entsprechenden Strom $(i_L(t))$, der sich über die Zeit ändert und durch das elektrische oder elektronische Leistungsbauteil (2) fließt, und eine entsprechende Oberflächentemperatur $(T_S)$;

C.4 Bestimmen des Satzes R von Reaktionsparametern durch die Datensteuerungs- und - verarbeitungseinheit (101) auf der Grundlage des Stroms $(i_L(t))$ und der dadurch erfassten Oberflächentemperatur $(T_S)$; und

C.5 Vergleichen jedes Elements des Satzes R von Ansprechparametern mit der Arbeitsgrenzbedingung durch die Datensteuerungs- und-verarbeitungseinheit (101); und

C.6 wenn die Bedingung der Arbeitsgrenze an diesem Punkt erfüllt ist:

> C.6.1 Auswahl eines neuen Punktes $P_n$ des dreidimensionalen mathematischen Raums (3) entlang des erste gewählte Erkundungsrichtung; und
>
> C.6.2 wenn der Punkt $P_n$ innerhalb des Erkundungsfeldes (4) liegt, zurück zu Schritt C.2; ansonsten weiter zu Schritt C.8

C.7 wenn die Bedingung der Arbeitsgrenze an diesem Punkt $P_n$ nicht erfüllt ist:

> C.7.1 wenn der soeben ausgewählte Punkt $P_n$ der Anfangspunkt des Erkundungsfeldes (4) ist:
>
> > C.7.1.1 Auswahl eines neuen Punktes $P_n$ des dreidimensionalen mathematischen Raumes (3),entlang der genannten ersten ausgewählten Erkundungsrichtung;
> > Und
> > C.7.1.2 wenn der neue Punkt $P_n$ innerhalb des Erkundungsfeldes (4) enthalten ist:
> >
> > > C.7.1.2.1 Durchführung der Schritte C.2-C.5 und
> > > C.7.1.2.2 wenn die Bedingung der Arbeitsgrenze in dem neuen Punkt $P_n$ nicht erfüllt ist.zurück zu Schritt C.7.1.1,
> > > Andernfalls kehren Sie zu Schritt C.6 zurück;
> >
> > ansonsten weiter zu Schritt C.8
>
> ansonsten
> C.7.2 wenn der soeben ausgewählte Punkt $P_n$ und der davor liegende Punkt $P_{n-1}$ entlang der ersten Erkundungsrichtung liegen:
>
> > C.7.2.1 Bestimmen und Speichern durch die Datensteuerungs- und-verarbeitungseinheit (101),in einer Speichereinheit die Koordinaten $(p^*_{n1}, p^*_{n2}, p^*_{n3})$ eines anderen Punktes $P^*_n$ der Drei- dimensionalen Raum 3, der in der Nachbarschaft des Punktes $P_n$ des Erkundungsfeldes (4) entlang der ersten gewählten Erkundungsrichtung enthalten ist, wobei die Bedingung der Arbeitsgrenze erfüllt ist;
> > C.7.2.2 Auswählen des Punktes $P_{n-1}$ vor dem $P_n$ und, ausgehend davon, eines neuen Punktes $P_n$ entlang der zweiten Erkundungsrichtung; und
> > C.7.2.3 wenn der neu ausgewählte Punkt $P_n$ innerhalb des Erkundungsfeldes (4) liegt, Rückkehr zu Schritt C.2;
> > ansonsten weiter zu Schritt C.8
>
> ansonsten
>
> C.7.3 wenn der soeben ausgewählte Punkt $P_n$ und der davor liegende Punkt $P_{n-1}$ entlang der zweiten Erkundungsrichtung liegen:
>
> > C.7.3.1 Auswählen eines neuen Punktes $P_n$ des dreidimensionalen mathematischen Raums (3) entlang der ersten ausgewählten Erkundungsrichtung; und
> > C.7.3.2 wenn der neu ausgewählte Punkt $P_n$ innerhalb des Erkundungsfeldes (4) liegt, Rückkehr zu Schritt C.2;
> > ansonsten weiter zu Schritt C.8

C.8, wenn der soeben ausgewählte Punkt $P_n$ nicht in dem Erkundungsfeld (4) liegt:

C.8.1 Auswählen eines neuen Punktes $P_n$ des dreidimensionalen mathematischen Raums (3) entlang der zweiten Erkundungsrichtung, ausgehend von dem zuvor ausgewählten Punkt $P_{n-1}$, und, wenn der neu ausgewählte Punkt $P_n$ in dem Erkundungsfeld (4) enthalten ist, Zurückgehen zum Schritt C.2; andernfalls C.8.2 Auswählen eines neuen Punktes $P_n$ des dreidimensionalen mathematischen Raums (3) entlang der dritten Erkundungsrichtung, ausgehend von dem zuvor ausgewählten Punkt $P_{n-1}$, und, wenn der neu ausgewählte Punkt $P_n$ in dem Erkundungsfeld (4) enthalten ist, Zurückgehen zum Schritt C.2; andernfalls Gehen zum Schritt D des Verfahrens.

13. Verfahren (1) nach Anspruch 12, bei dem die gespeicherten Koordinaten des Punktes $P^*_n$ des mathematischen Raums (3), der in der Nachbarschaft des Punktes $P_n$ des Erkundungsfeldes (4) liegt, durch eine Interpolationsformel, gegebenenfalls eine lineare, berechnet werden.

14. Verfahren (1) nach einem der vorhergehenden Ansprüche, wobei der Schritt D darin besteht, auf die Punkte $P^*_n$ des mathematischen Raums (3), der dadurch gespeichert wird, über die Datensteuerungs- und -verarbeitungseinheit (101) mindestens einen Algorithmus der genetischen Programmierung oder der grammatikalischen Evolution anzuwenden.

15. Messplatz (100), konfiguriert zur Durchführung des Verfahrens (1) zur Bestimmung des Verhaltens eines elektrischen oder elektronischen Leistungsbauteils (2) nach einem der vorhergehenden Ansprüche, umfassend:

   - eine Datensteuerungs- und -verarbeitungseinheit (101), die so konfiguriert ist, dass sie den dreidimensionalen mathematischen Raum (3), das Erkundungsfeld (4), die Arbeitsgrenzbedingung und den Satz R von Antwortparametern definiert und jedes Element des Satzes R, das für die erkundeten Punkte des dreidimensionalen mathematischen Raums (3) bestimmt wurde, mit der Arbeitsgrenzbedingung vergleicht;
   - eine Anregung -Erzeugungsvorrichtung (102), die operativ mit der Datensteuerungs-und-verarbeitungseinheit (101) verbunden ist und so konfiguriert ist, dass sie mindestens eine Anregung erzeugt, wobei die Anregung mindestens eine Nullmittel- und Rechteckspannung $v_L(t)$ und einen konstanten Durchschnittsstrom $I_L$ für das elektrische oder elektronische Leistungsbauteil (2) umfasst, auf der Grundlage des Wertes der Koordinaten des Punktes $P_n$ des dreidimensionalen mathematischen Raums (3), wobei die Koordinaten den jeweiligen Werten der Betriebsparameter ($V_{eq}$, $f_{sw}$, $I_L$) des elektrischen oder elektronischen Leistungsbauteils (2) zugeordnet sind, und um die so erzeugte Anregung auf das elektrische oder elektronische Leistungsbauteil (2) anzuwenden;
   - eine Erfassungsvorrichtung (103), die operativ mit der Datensteuerungs-und-verarbeitungseinheit (101) verbunden ist und so konfiguriert ist, dass sie den mindestens einen sich über die Zeit verändernden Strom $i_L(t)$ und eine Oberflächentemperatur $T_s$ des elektrischen oder elektronischen Leistungsbauteils (2) als Antwort auf die dadurch angelegte Anregung erfasst;
   - mindestens eine Speichereinheit (104), die operativ mit der Datensteuerungs-und-verarbeitungseinheit (101) verbunden und zum Speichern der Koordinaten der Punkte $P^*_n$ des mathematischen Raums (3) konfiguriert ist, in dem die Arbeitsgrenzbedingung erfüllt ist;

   wobei die Datensteuerungs-und-verarbeitungseinheit (101) so konfiguriert ist, dass sie auf die Koordinaten der dadurch gespeicherten Punkte $P^*_n$ mindestens einen mathematischen Algorithmus, optional einen Algorithmus der genetischen Programmierung oder der grammatikalischen Evolution, anwendet, wobei der mindestens eine mathematische Algorithmus am Ausgang eine Beschreibung in analytischer Form der Ortskurve der Punkte $P^*_n$ und somit der Ortskurve (5) der entsprechenden Betriebsparameter liefert, die eine Reaktion des elektrischen oder elektronischen Leistungsbauteils (2) bestimmen, die die mindestens eine Arbeitsgrenzbedingung erfüllt.

16. Messplatz (100) nach Anspruch 15, wobei die eine Anregung erzeugende Vorrichtung (102) und die Erfassungsvorrichtung (103) werden durch drei Leistungswandlerstufen erhalten, die gemäß einem Oppositionsverfahren in Kaskade geschaltet sind, um:

   - die mindestens eine elektrische oder elektronische Leistungskomponente (2) dem mindestens eine Anregung unterwirft, basierend auf dem Wert der Koordinaten des Punktes $P_n$; und
   - mindestens einen über die Zeit variierenden Strom $i_L(t)$ und eine Oberflächentemperatur T des elektrischen oder elektronischen Leistungsbauteils (2) zu erfassen.

17. Messplatz (100) nach Anspruch 15 oder 16, wobei die drei Wandler eine Eingangsstufe (SdI), eine Teststufe (SdT) und eine Ausgangsstufe (SdU) umfassen, wobei die Teststufe (SdT) zwischen die Eingangsstufe (SdI) und die

Ausgangsstufe (SdT) geschaltet ist und ferner so konfiguriert ist, dass sie mit dem elektrischen oder elektronischen Leistungsbauteil (2) verbunden ist.

18. Messplatz (100) nach Anspruch 17, die stromabwärts der Ausgangsstufe (SdU) ein Schaltelement (SPDT) für den von der Ausgangsstufe (SdU) ausgegebenen Strom in Richtung des Eingangs der Teststufe (SdT) oder einer externen Last (EL) umfasst.

19. Messplatz (100) nach Anspruch 17 oder 18, wobei die Eingangsstufe (SdI) so konfiguriert ist, dass sie in einer geschlossenen Schleife arbeitet und am Eingang der Teststufe (SdT) eine Gleichspannung durch Einstellung ihrer Ausgangsspannung ($V_i$) bereitstellt, und wobei die Teststufe (SdT) so konfiguriert ist, dass sie in einer offenen Schleife arbeitet und eine Schaltfrequenz der Nullmittel- und Rechteckspannung $V_L(t)$ durch Einstellung ihrer eigenen Frequenz ($f_t$) und ihres Tastverhältnisses ($D_t$) bereitstellt.

20. Messplatz (100) nach einem der Ansprüche 17 bis 19, wobei die Ausgangsstufe (SdU) so konfiguriert ist, dass sie im geschlossenen Regelkreis arbeitet und am Ausgang der Teststufe (SdT) einen Gleichstrom durch Einstellung ihres eigenen durchschnittlichen Eingangsstroms erzeugt.

21. Messplatz (100) nach einem der Ansprüche 15 bis 20, umfassend:

   - eine gedruckte Schaltung (105) mit leitenden Pfaden (106), die so konfiguriert sind, dass sie die Anregung auf das elektrische oder elektronische Leistungsbauteil (2) ausüben, wobei die leitenden Pfade (106) mindestens einen Oberflächenabschnitt (1061) aufweisen, der so konfiguriert ist, dass er mit des elektrischen oder elektronischen Leistungsbauteils (2) in elektrischen Kontakt tritt; und
   - ein Positionierungssystem (107) für das elektrische oder elektronische Leistungsbauteil (2) und die gedruckte Schaltung (105), wobei das elektrische oder elektronische Leistungsbauteil (2) in elektrischem Kontakt mit den Leiterbahnen (106) der gedruckten Schaltung (105) steht, ohne dass Schweißnähte erforderlich sind.

22. Messplatz (100) nach Anspruch 21, wobei das Positionierungssystem (107) umfasst:

   - eine Positionierungsplatte (1071) und
   - eine Gruppe (1072) für die elastische Verankerung der Positionierungsplatte (1071) an der gedruckten Schaltung (105); wobei das elektrische oder elektronische Leistungsbauteil (2) so konfiguriert ist, dass es zwischen der gedruckten Schaltung (105) und der Positionierungsplatte (1071) angeordnet und einem Druck ausgesetzt ist in Richtung der Leiterbahnen (106) der gedruckten Schaltung (105), durch die elastische Verankerungsgruppe (1072).

23. Messplatz (100) nach Anspruch 22, wobei die elastische Verankerungsgruppe (1072) ein Paar von elastisch geladenen Schrauben (10721) umfasst, die so konfiguriert sind, dass sie in die gedruckte Schaltung geschraubt werden können, indem sie durch geeignete Öffnungen in den Positionierungsplatten (1071) geführt werden.

24. Messplatz (100) nach einem der Ansprüche 21 bis 23, wobei die Leiterbahnen (106) eine polygonale, gegebenenfalls trapezförmige Konfiguration aufweisen.

25. Messplatz (100) nach einem der Ansprüche 21 bis 24, wobei die Erfassungsvorrichtung (103) mindestens einen Temperatursensor umfasst, der funktionell mit der Datensteuerungs-und -verarbeitungseinheit (101) verbunden und so konfiguriert ist, dass er die Oberflächentemperatur ($T_s$) des elektrischen oder elektronischen Leistungsbauteils (2) erfasst und an die Datensteuerungs- und -verarbeitungseinheit (101) überträgt.

26. System (1000) zur Durchführung des Verfahrens (1) zur Bestimmung des Verhaltens einer elektrischen oder elektronischen Leistungskomponente (2) nach einem der vorhergehenden Ansprüche, umfassend mindestens eine Messstation (100) nach einem der Ansprüche 15 bis 25 und mindestens eine Fernverarbeitungseinheit (200), wobei die Messstation (100) und die Fernverarbeitungseinheit (200) operativ miteinander verbunden sind, wahlweise über ein Netzwerk, wahlweise über ein Kabel oder drahtlos, und wobei die Datensteuerungs- und -verarbeitungseinheit (101) der Messstation (100) so konfiguriert ist, dass sie an die mindestens eine Fernverarbeitungseinheit (200) die Koordinaten der Punkte $P^*_n$ sendet, die dadurch gespeichert werden, und die mindestens eine Fernverarbeitungseinheit (200) so konfiguriert ist, dass sie mindestens einen mathematischen Algorithmus anwendet, gegebenenfalls einen Algorithmus der genetischen Programmierung oder der grammatikalischen Evolution, anzuwenden, der am Ausgang eine Beschreibung in analytischer Form der Ortskurve der Punkte $P^*_n$ und somit der Ortskurve (5) der entsprechenden Betriebsparameter liefert, die eine Antwort des elektrischen oder elektronischen Leistungsbauteils (2) bestimmen, die mindestens eine Arbeitsgrenzbedingung erfüllt.

## Revendications

1. Procédé (1) de détermination du comportement d'un composant de puissance électrique ou électronique (2), par rapport à une condition limite de fonctionnement, le procédé comprenant les étapes opérationnelles suivantes :

   A. définition d'un espace mathématique tridimensionnel (3) de paramètres opérationnels d'intérêt pour ledit composant de puissance électrique ou électronique (2), où les coordonnées d'un n-ième point $P_n$ dudit espace mathématique tridimensionnel (3) correspondent à des valeurs spécifiques desdits paramètres opérationnels d'intérêt pour ledit composant de puissance électrique ou électronique (2) ;
   B. définition d'un champ d'exploration (4) dudit espace mathématique tridimensionnel (3), de la condition limite de fonctionnement pour ledit composant de puissance électrique ou électronique (2) et d'un ensemble R de paramètres de réponse d'intérêt pour ledit composant de puissance électrique ou électronique (2) ;
   **caractérisé par** les étapes opérationnelles supplémentaires suivantes :
   C. exploration dudit espace mathématique tridimensionnel (3) par :

      - la génération d'au moins un stimulus, déterminé sur la base des coordonnées des points $P_n$ dudit espace mathématique tridimensionnel (3) et dudit champ d'exploration (4),
      - l'application dudit au moins un stimulus audit au moins un composant de puissance électrique ou électronique (2), et
      - la détection d'une réponse correspondante audit stimulus ainsi appliqué, à partir dudit composant de puissance électrique ou électronique (2), et

      sur la base de ladite réponse ainsi détectée, la détermination et le stockage d'un sous-ensemble fini de points $P^*_n$ dudit espace mathématique tridimensionnel (3), parmi les points $P_n$ dudit espace mathématique tridimensionnel (3), pour lequel ladite condition limite de fonctionnement dudit composant de puissance électronique (2) est satisfaite ; et
      D. détermination d'un modèle mathématique qui décrit analytiquement le lieu desdits points $P^*_n$ dudit espace mathématique tridimensionnel (3) ainsi stockés, obtenant ainsi le lieu (5) desdits paramètres opérationnels qui déterminent une réponse dudit composant de puissance électrique ou électronique (2) qui satisfait ladite condition limite de fonctionnement.

2. Procédé (1) selon la revendication 1, dans lequel lesdits paramètres opérationnels d'intérêt pour ledit composant de puissance électrique ou électronique (2) sont sélectionnés parmi :

   - une tension équivalente ($V_{eq}$) à appliquer audit composant de puissance électrique ou électronique (2) ;
   - une fréquence de commutation ($f_{sw}$) pour un cycle complet de charge-décharge dudit composant de puissance électrique ou électronique (2) ;
   - un courant moyen ($I_L$) circulant à travers ledit composant de puissance électrique ou électronique (2) ; et
   - une température ($T_a$) de l'environnement dans lequel ledit composant de puissance électrique ou électronique (2) est opérationnel.

3. Procédé (1) selon la revendication 1 ou 2, dans lequel ledit espace mathématique tridimensionnel (3) est défini en attribuant à chacun desdits paramètres opérationnels d'intérêt dudit composant de puissance électrique ou électronique (2), un axe mathématique correspondant d'un espace mathématique tridimensionnel euclidien.

4. Procédé (1) selon l'une des revendications précédentes, dans lequel ledit au moins un champ d'exploration (4) est défini en sélectionnant :

   - un sous-ensemble fini de points $P_n$ dudit espace mathématique tridimensionnel (3) ; et
   - un ensemble ordonné de trois directions d'exploration des points dudit champ d'exploration (4), à partir de n'importe quel point $P_{n-1}$ jusqu'au point suivant $P_n$, chaque direction d'exploration étant facultativement parallèle à un axe respectif dudit espace mathématique tridimensionnel (3).

5. Procédé selon la revendication 4, dans lequel l'exploration dudit espace mathématique tridimensionnel (3) est réalisée, à partir d'un point de départ $P_n$ dudit champ d'exploration (4), le long desdites directions d'exploration, de manière ordonnée, et selon une règle d'exploration telle que les coordonnées d'un n-ième point exploré $P_n$ dudit espace mathématique tridimensionnel (3) diffèrent de celles d'un point précédent $P_{n-1}$, pour la valeur d'un ou de plusieurs de leurs composants.

6. Procédé selon la revendication 4 ou 5, dans lequel les coordonnées $(p_{n1}, p_{n2}, p_{n3})$ des points $P_n$ dudit champ d'exploration (4) ont des valeurs comprises entre une valeur minimale et une valeur maximale de paramètres opérationnels respectifs $(V_{eq}, f_{sw}, I_L)$ et dans lequel le nombre fini desdits points $P_n$ dudit champ d'exploration (4) est fonction, pour chacune desdites directions d'exploration dudit espace mathématique tridimensionnel :

   - d'un nombre d'échantillons $(NV_{eq}, Nf_{sw}, NI_L)$ ; et
   - d'un décalage $(\Delta V_{eq}, \Delta f_{sw}, \Delta I_L)$ entre un échantillon et le suivant le long de la direction d'exploration respective.

7. Procédé selon la revendication 6, dans lequel pour chaque direction desdites directions d'exploration :

   - ledit nombre d'échantillons $(NV_{eq}, Nf_{sw}, NI_L)$ est fixe, et ledit décalage $(\Delta V_{eq}, \Delta f_{sw}, \Delta I_L)$ est fixe et constant ; ou
   - ledit nombre d'échantillons $(NV_{eq}, Nf_{sw}, NI_L)$ est fixe, et ledit décalage $(\Delta V_{eq,i}, \Delta f_{sw,j}, \Delta I_{L,K})$ varie entre deux échantillons ultérieurs, facultativement selon une fonction pouvant être sélectionnée entre une fonction prédéfinie logarithmique, de puissance, trigonométrique, transcendante ou de série numérique ; ou
   - ledit nombre d'échantillons $(NV_{eq}, Nf_{sw}, NI_L)$ dépend d'un décalage $(\Delta V_{eq,i}, \Delta f_{sw,j}, \Delta I_{L,K})$ qui est calculé, pendant ladite exploration dudit champ d'exploration (4), pour chaque point $P_n$, facultativement sur la base d'une valeur d'un ensemble R de paramètres de réponse, lesquels paramètres de réponse sont calculés aux deux derniers points $P_{n-1}$ e $P_{n-2}$ explorés dans ledit champ d'exploration (4).

8. Procédé (1) selon l'une des revendications précédentes, dans lequel la conformité ou non de ladite condition limite de fonctionnement dans n'importe quel point $P_n$ dudit espace mathématique tridimensionnel (3) dépend de la valeur d'au moins un paramètre de réponse dudit ensemble R de paramètres de réponse dudit composant de puissance électrique ou électronique (2), les paramètres de réponse étant déterminés sur la base de la réponse détectée à partir dudit composant de puissance électrique ou électronique (2), après l'application dudit stimulus à ses bornes, et d'une logique de recherche prédéfinie.

9. Procédé (1) selon la revendication 8, dans lequel ledit paramètre de réponse dudit ensemble R de paramètres de réponse dudit composant de puissance électrique ou électronique (2) est l'une parmi :

   - une variation crête à crête $(\Delta i_{Lpp})$ d'un courant $(i_L(t))$ qui varie dans le temps et circule à travers ledit composant de puissance électrique ou électronique (2) ;
   - une température de surface $(T_s)$ dudit composant de puissance électrique ou électronique (2) ;
   - une puissance électrique moyenne $(P_d)$ dissipée par ledit composant de puissance électrique ou électronique (2).

10. Procédé (1) selon la revendication 8 ou 9, dans lequel ladite condition limite de fonctionnement dudit composant de puissance électrique ou électronique (2) est fonction d'une valeur seuil préfixée $(\Delta i_{Lpp,ref}, T_{s,ref}, P_{d,ref})$ pour chaque paramètre de réponse.

11. Procédé (1) selon la revendication 10, dans lequel ledit au moins un paramètre de réponse est conforme à ladite au moins une condition limite de fonctionnement si sa valeur est inférieure ou égale à une valeur seuil respective $(\Delta i_{Lpp,ref}, T_{s,ref}, P_{d,ref})$.

12. Procédé (1) selon l'une quelconque des revendications précédentes, dans lequel ladite étape C comprend :

   C.1 la sélection, par une unité de commande et de traitement de données (101), d'un point de départ $P_n$ compris dans ledit champ d'exploration (4) et une première direction d'exploration dudit champ d'exploration (4) ;
   C.2 la génération, par un dispositif de génération de stimulus, d'un stimulus comprenant une tension $v_L(t)$ variable dans le temps et un courant moyen constant $I_L$, sur la base de la valeur des coordonnées dudit point $P_n$ qui vient d'être sélectionné, et l'application dudit stimulus ainsi généré aux bornes dudit composant de puissance électrique ou électronique (2) ;
   C.3 la détection au niveau des bornes dudit composant de puissance électrique ou électronique (2), par un dispositif de détection, en réponse audit stimulus ainsi appliqué, d'au moins un courant correspondant $(i_L(t))$

qui varie dans le temps et circule à travers ledit composant de puissance électrique ou électronique (2), et d'une température de surface correspondante ($T_s$) ;

C.4 la détermination, par ladite unité de commande et de traitement de données (101), dudit ensemble R de paramètres de réponse, sur la base dudit courant ($i_L(t)$) et de ladite température de surface ($T_s$) ainsi détectés ; et

C.5 la comparaison, par ladite unité de commande et de traitement de données (101), de chaque élément dudit ensemble R de paramètres de réponse avec ladite condition limite de fonctionnement ; et

C.6 si ladite condition limite de fonctionnement est satisfaite audit point $P_n$ :

> C.6.1 la sélection d'un nouveau point $P_n$ dudit espace mathématique tridimensionnel (3), le long de ladite première direction d'exploration sélectionnée ; et
>
> C.6.2 si ledit point $P_n$ est compris dans ledit champ d'exploration (4), le retour à l'étape C.2 ;
> sinon le passage à l'étape C.8

C.7 si ladite condition limite de fonctionnement n'est pas satisfaite audit point $P_n$ ;

> C.7.1 si ledit point $P_n$ qui vient d'être sélectionné est le point de départ dudit champ d'exploration (4) :
>
>> C.7.1.1 la sélection d'un nouveau point $P_n$ dudit espace mathématique tridimensionnel (3), le long de ladite première direction d'exploration sélectionnée ; et
>>
>> C.7.1.2 si ledit nouveau point $P_n$ est compris dans ledit champ d'exploration (4) :
>>
>>> C.7.1.2.1 la réalisation des étapes C.2-C.5 et
>>> C.7.1.2.2 si ladite condition limite de fonctionnement n'est pas satisfaite dans ledit nouveau point $P_n$, le retour à l'étape C.7.1.1,
>>> sinon, le retour à l'étape C.6 ;
>>
>> sinon le passage à l'étape C.8
>
> sinon
> C.7.2 si ledit point $P_n$ qui vient d'être sélectionné et le point $P_{n-1}$ qui le précède sont situés le long de ladite première direction d'exploration :
>
>> C.7.2.1 la détermination, par ladite unité de commande et de traitement de données (101), et le stockage, dans une unité de stockage, des coordonnées ($p^*_{n1}$, $p^*_{n2}$, $p^*_{n3}$) d'un autre point $P^*_n$ de l'espace tridimensionnel 3, qui est compris au voisinage dudit point $P_n$ dudit champ d'exploration (4), le long de ladite première direction d'exploration sélectionnée, où ladite condition limite de fonctionnement est satisfaite ;
>>
>> C.7.2.2 la sélection du point $P_{n-1}$ avant ledit $P_n$ et, à partir de là, d'un nouveau point $P_n$ le long de la deuxième direction d'exploration ; et
>>
>> C.7.2.3 si ledit point $P_n$ nouvellement sélectionné est compris dans ledit champ d'exploration (4), le retour à l'étape C.2 ;
>> sinon le passage à l'étape C.8
>
> sinon
> C.7.3 si ledit point $P_n$ qui vient d'être sélectionné et le point $P_{n-1}$ qui le précède sont placés le long de la deuxième direction d'exploration :
>
>> C.7.3.1 la sélection d'un nouveau point $P_n$ de l'espace mathématique tridimensionnel (3), le long de la première direction d'exploration sélectionnée ; et
>>
>> C.7.3.2 si ledit point $P_n$ nouvellement sélectionné est compris dans ledit champ d'exploration (4), le retour à l'étape C.2 ;
>> sinon le passage à l'étape C.8

C.8 si ledit point $P_n$ qui vient d'être sélectionné n'est pas compris dans ledit champ d'exploration (4) :

> C.8.1 la sélection, le long de ladite deuxième direction d'exploration, d'un nouveau point $P_n$ de l'espace mathématique tridimensionnel (3), à partir du point $P_{n-1}$ précédemment sélectionné et, si le point $P_n$ nouvellement sélectionné est compris dans ledit champ d'exploration (4), le retour à l'étape C.2 ; sinon

C.8.2 la sélection, le long de ladite troisième direction d'exploration, d'un nouveau point $P_n$ de l'espace mathématique tridimensionnel (3), à partir du point $P_{n-1}$ précédemment sélectionné et, si le point $P_n$ nouvellement sélectionné est compris dans ledit champ d'exploration (4), le retour à l'étape C.2 ; sinon le passage à ladite étape D dudit procédé.

13. Procédé (1) selon la revendication 12, dans lequel les coordonnées stockées dudit point $P^*_n$ dudit espace mathématique (3), lequel point est compris au voisinage dudit point $P_n$ dudit champ d'exploration (4), sont calculées au moyen d'une formule d'interpolation, facultativement linéaire.

14. Procédé (1) selon l'une des revendications précédentes, dans lequel ladite étape D comprend l'application auxdits points $P^*_n$ dudit espace mathématique (3) ainsi stocké, par ladite unité de commande et de traitement de données (101), d'au moins un algorithme de Programmation Génétique ou d'Evolution Grammaticale.

15. Station de mesure (100), configurée pour mettre en oeuvre le procédé (1) de détermination du comportement d'un composant de puissance électrique ou électronique (2) selon l'une des revendications précédentes, comprenant :

- une unité de commande et de traitement de données (101), configurée pour définir ledit espace mathématique tridimensionnel (3), ledit champ d'exploration (4), ladite condition limite de fonctionnement, ledit ensemble R de paramètres de réponse, et pour comparer chaque élément dudit ensemble R, déterminé pour les points explorés dudit espace mathématique tridimensionnel (3), avec ladite condition limite de fonctionnement ;
- un dispositif de génération de stimulus (102), relié de manière fonctionnelle à ladite unité de commande et de traitement de données (101) et configuré pour générer au moins un stimulus, le stimulus comprenant au moins une tension rectangulaire et à moyenne nulle $v_L(t)$ et un courant moyen constant $I_L$ pour ledit composant de puissance électrique ou électronique (2), sur la base de la valeur des coordonnées dudit point $P_n$ dudit espace mathématique tridimensionnel (3), lesdites coordonnées étant associées à des valeurs respectives desdits paramètres opérationnels ($V_{eq}$, $fs_w$, $I_L$) dudit composant de puissance électrique ou électronique (2), et pour appliquer ledit stimulus ainsi généré audit composant de puissance électrique ou électronique (2) ;
- un dispositif de détection (103), relié de manière fonctionnelle à ladite unité de commande et de traitement de données (101) et configuré pour détecter ledit au moins un courant $i_L(t)$ variable dans le temps et une température de surface $T_s$ dudit composant de puissance électrique ou électronique (2), en réponse audit stimulus ainsi appliqué ;
- au moins une unité de stockage (104), reliée de manière fonctionnelle à ladite unité de commande et de traitement de données (101) et configurée pour stocker les coordonnées des points $P^*_n$ dudit espace mathématique (3)

dans laquelle ladite condition limite de fonctionnement est satisfaite ;
dans laquelle ladite unité de commande et de traitement de données (101) est configurée pour appliquer auxdites coordonnées desdits points $P^*_n$ ainsi stockées, au moins un algorithme mathématique, facultativement un algorithme de Programmation Génétique ou d'Evolution Grammaticale, ledit au moins un algorithme mathématique fournissant en sortie une description, sous forme analytique, du lieu desdits points $P^*_n$, et ainsi du lieu (5) des paramètres opérationnels correspondants qui déterminent une réponse provenant dudit composant de puissance électrique ou électronique (2) qui satisfait ladite au moins une condition limite de fonctionnement.

16. Station de mesure (100), selon la revendication 15, dans laquelle ledit dispositif de génération de stimulus (102) et ledit dispositif de détection (103) sont obtenus à travers trois étages de convertisseur de puissance reliés de manière fonctionnelle en cascade selon une méthode d'Opposition, de manière à :

- soumettre ledit au moins un composant de puissance électrique ou électronique (2) audit au moins un stimulus, sur la base de la valeur des coordonnées dudit point $P_n$ ; et
- détecter au moins un courant $i_L(t)$ variable dans le temps et une température de surface $T_s$ dudit composant de puissance électrique ou électronique (2).

17. Station de mesure (100) selon la revendication 15 ou 16, dans laquelle lesdits trois convertisseurs comprennent un étage d'entrée (SdI), un étage de test (SdT) et un étage de sortie (SdU), dans laquelle l'étage de test (SdT) est relié entre l'étage d'entrée (SdI) et l'étage de sortie (SdT) et est en outre configuré pour être relié audit composant de puissance électrique ou électronique (2).

18. Station de mesure (100) selon la revendication 17, comprenant en aval dudit étage de sortie (SdU) un élément de commutation (SPDT) du courant délivré en sortie dudit étage de sortie (SdU), vers l'entrée de l'étage de test (SdT) ou une charge externe (EL).

19. Station de mesure (100) selon la revendication 17 ou 18, dans laquelle ledit étage d'entrée (SdI) est configuré pour fonctionner en boucle fermée et fournir en entrée audit étage de test (SdT) une tension continue, par ajustement de la tension de sortie (Vi) de celui-ci, et ledit étage de test (SdT) est configuré pour fonctionner en boucle ouverte et fournir une fréquence de commutation de ladite tension rectangulaire et à moyenne nulle $v_L(t)$, par ajustement de sa propre fréquence (ft) et de son rapport cyclique (Dt).

20. Station de mesure (100) selon l'une des revendications 17 à 19, dans laquelle ledit étage de sortie (SdU) est configuré pour fonctionner en boucle fermée et imposer en sortie dudit étage de test (SdT) un courant continu, par ajustement de son propre courant moyen d'entrée.

21. Station de mesure (100) selon l'une des revendications 15 à 20, comprenant :

   - un circuit imprimé (105) ayant des chemins conducteurs (106), configuré pour imposer ledit stimulus audit composant de puissance électrique ou électronique (2), où lesdits chemins conducteurs (106) ont au moins une partie de surface (1061) configurée pour entrer électriquement en contact avec ledit composant de puissance électrique ou électronique (2) ; et
   - un système de positionnement (107) dudit composant de puissance électrique ou électronique (2) sur ledit circuit imprimé (105), où ledit composant de puissance électrique ou électronique (2) est en contact électrique avec lesdits chemins conducteurs (106) dudit circuit imprimé (105), sans nécessité de soudures.

22. Station de mesure (100) selon la revendication 21, dans laquelle ledit système de positionnement (107) comprend :

   - une plaque de positionnement (1071) ; et
   - un groupe (1072) pour l'ancrage élastique de ladite plaque de positionnement (1071) audit circuit imprimé (105) ;

   ledit composant de puissance électrique ou électronique (2) étant configuré pour être placé entre ledit circuit imprimé (105) et ladite plaque de positionnement (1071) et étant soumis à une pression vers lesdits chemins conducteurs (106) dudit circuit imprimé (105), par ledit groupe d'ancrage élastique (1072).

23. Station de mesure (100) selon la revendication 22, dans laquelle ledit groupe d'ancrage élastique (1072) comprend un couple de vis chargées élastiquement (10721), configurées pour être vissées sur ledit circuit imprimé, passant à travers des ouvertures appropriées obtenues dans lesdites plaques de positionnement (1071).

24. Station de mesure (100) selon l'une des revendications 21 à 23, dans laquelle lesdits chemins conducteurs (106) ont une configuration polygonale, facultativement trapézoïdale.

25. Station de mesure (100) selon l'une des revendications 21 à 24, dans laquelle ledit dispositif de détection (103) comprend au moins un capteur de température, relié de manière fonctionnelle à ladite unité de commande et de traitement de données (101) et configuré pour détecter ladite température de surface ($T_s$) dudit composant de puissance électrique ou électronique (2) et pour la transmettre à ladite unité de commande et de traitement de données (101).

26. Système (1000) pour la mise en oeuvre du procédé (1) de détermination du comportement d'un composant de puissance électrique ou électronique (2) selon l'une des revendications précédentes, comprenant au moins une station de mesure (100) selon l'une des revendications 15 à 25 et au moins une unité de traitement à distance (200), dans lequel ladite station de mesure (100) et ladite unité de traitement à distance (200) sont reliées de manière fonctionnelle l'une à l'autre, facultativement via un réseau, facultativement via un câble ou sans fil, et dans lequel ladite unité de commande et de traitement de données (101) de ladite station de mesure (100) est configurée pour envoyer à ladite au moins une unité de traitement à distance (200) lesdites coordonnées desdits points $P^*_n$ ainsi stockées, et ladite au moins une unité de traitement à distance (200) est configurée pour appliquer au moins un algorithme mathématique, facultativement un algorithme de Programmation Génétique ou d'Evolution Grammaticale, fournissant en sortie une description, sous forme analytique, du lieu desdits points $P^*_n$, et donc du lieu (5) des paramètres opérationnels correspondant qui déterminent une réponse provenant dudit composant de puissance électrique ou électronique (2) qui satisfait au moins une condition limite de fonctionnement.

**Fig. 1**

**Fig. 2**

C

```
            ┌─────────┐
            │   C.1   │
            └─────────┘
                 │
                 ▼
            ┌─────────┐
            │   C.2   │
            └─────────┘
                 │
                 ▼
            ┌─────────┐
            │   C.3   │
            └─────────┘
                 │
                 ▼
            ┌─────────┐
            │   C.4   │
            └─────────┘
                 │
                 ▼
```

◇ C.7.1

◇ C.7.2   ◇ C.7   ←── NO ──   ◇ C.5

◇ C.7.3                          │ YES
                                 ▼
                          ┌─────────┐
                          │   C.6   │
                          └─────────┘

**Fig. 3**

C.6

```
            ┌─────────┐
            │  C.6.1  │
            └─────────┘
                 │
                 ▼
```

◇ C.7   ←── NO ──   ◇ C.6.2

                         │ YES
                         ▼
                  ┌─────────┐
                  │   C.2   │
                  └─────────┘

**Fig. 4a**

**Fig. 4b**

**Fig. 4c**

**Fig. 4d**

**Fig. 5**

**Fig. 6**

**Fig. 7**

Fig. 8a

Fig. 8b

Fig. 9

Fig. 10

Fig. 11a

Fig. 11b

Fig. 12

EP 4 241 094 B1

**Fig. 13**

**Fig. 14**

**Fig. 15**

**Fig. 16**

**Fig. 17**

**Fig. 18**

**Fig. 19**

**Fig. 20**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2807589 B1
- US 7307412 B1
- US 20120316817 A1
- US 5793640 A
- US 20160132625 A

### Non-patent literature cited in the description

- **J. R. KOZA.** Genetic Programming: On the Programming of Computers by Means of Natural Selection. MIT Press, 1992
- **J.F. MILLER.** Cartesian Genetic Programming. Springer
- **C. RYAN ; M. O'NEILL ; MICHAEL, J.J. COLLINS.** Handbook of Grammatical Evolution. Springer
- **F. FOREST et al.** Use of opposition method in the test of high-power electronic converters. *IEEE Transactions on Industrial Electronics,* April 2006, vol. 53 (2), 530-541